# FASCICULE DE BREVET EUROPEEN

(11) **EP 3 457 491 B1**
(45) Date de publication et mention de la délivrance du brevet: **17.06.2020**
(21) Numéro de dépôt: 18193593.3
(22) Date de dépôt: 11.09.2018
(51) Int. Cl.: H01P 1/10, H01L 45/00

(54) **SYSTÈME DE DÉCOUPLAGE RF/DC POUR COMMUTATEURS RF À BASE DE MATÉRIAU À CHANGEMENT DE PHASE**
RF/DC-ENTKOPPELUNGSSYSTEM FÜR RF-SCHALTER AUF DER BASIS VON PHASENWECHSELMATERIAL
SYSTEM FOR RF/DC DECOUPLING FOR RF SWITCHES MADE FROM PHASE CHANGE MATERIAL

(30) Priorité: 19.09.2017 FR 1758680
(43) Date de publication de la demande: 20.03.2019
(73) Titulaire: Commissariat à l'énergie atomique et aux énergies alternatives, 75015 Paris (FR)
(72) Inventeur: REIG, Bruno, 38430 Moirans (FR); LEON, Alexandre, 38360 Sassenage (FR); SAINT-PATRICE, Damien, 26120 Chabeuil (FR)
(74) Mandataire: Brevalex

(56) Documents cités:
- US-A1- 2006 102 927
- US-A1- 2016 056 373

## Description

### DOMAINE TECHNIQUE ET ART ANTÉRIEUR

La présente demande se rapporte au domaine des commutateurs RF intégrant un matériau à changement de phase et concerne en particulier ceux réalisés en couches minces et qui peuvent faire partie d'un circuit intégré ou d'un dispositif électronique.

Un commutateur RF est une structure destinée à modifier de manière réversible les connexions électriques entre des éléments d'un circuit RF.

Les commutateurs RF sont habituellement réalisés à partir de composants électroniques tels que les transistors à effet de champ ou les diodes PIN (pour « Positive Intrinsic Negative ») ou à l'aide de relais électro-mécaniques de type MEMS.

Des commutateurs RF intégrant un matériau à changement de phase (PCM pour « Phase Change Material ») sont également apparus.

Le fonctionnement d'un commutateur RF à base de matériau PCM s'appuie typiquement sur deux états que ce matériau est susceptible d'adopter :
- un état amorphe à haute résistivité, qui correspond à un état bloqué du commutateur lors duquel la transmission d'un signal RF entre au moins deux bornes est empêchée,
- un état cristallin à faible résistivité, qui correspond à un état passant du commutateur lors duquel la transmission du signal RF entre les deux bornes est permise.

Les deux états étant stables, il n'est pas nécessaire de maintenir un courant/tension pour maintenir un état ce qui permet une économie de puissance en comparaison d'autres technologies tels que les commutateurs à base de FET ou de diode PIN.

Par ailleurs, un commutateur doté d'un matériau PCM permet d'acheminer des signaux d'une puissance plus importante que celle des signaux habituellement véhiculés par les commutateurs MEMS.

Le document US 2014/0266517 A1, prévoit un exemple d'interrupteur doté d'un matériau PCM inséré entre une ligne conductrice d'entrée et une ligne conductrice de sortie par lesquelles un signal RF est destiné à transiter.

Le changement de phase du matériau PCM est obtenu en faisant passer une impulsion de courant dans des électrodes de commande dédiées.

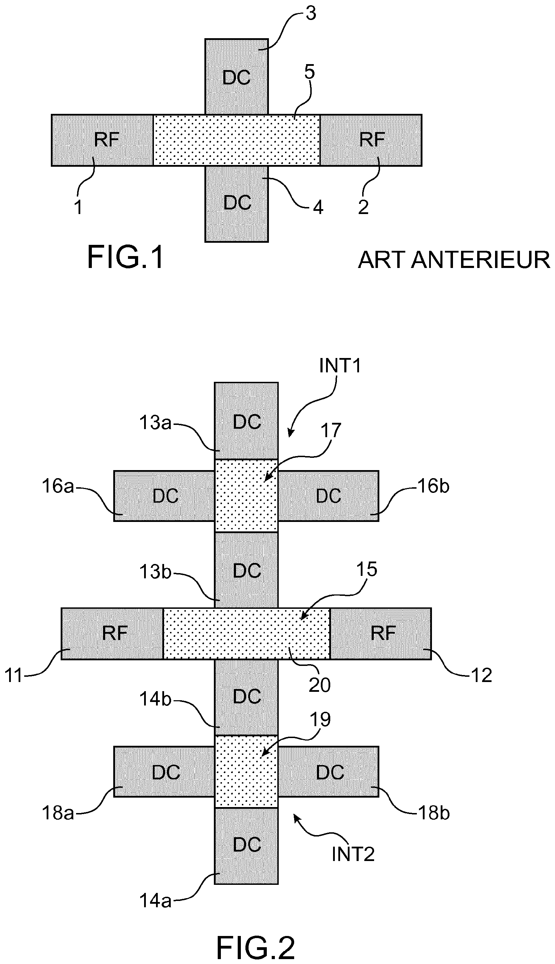

Un exemple particulier de structure de commutateur PCM est illustré sur la figure 1.

Le commutateur RF est doté d'une région 5 à base de PCM susceptible d'adopter alternativement, un état amorphe de haute résistivité, qui est assimilé à un état bloqué (OFF) dans lequel une transmission du signal RF est empêchée et un état cristallin qui est assimilé à un état passant (ON) dans lequel un signal RF est susceptible d'être transmis entre deux éléments conducteurs 1, 2 disposés de part et d'autre de la région 5 de matériau PCM.

La commutation entre état bloqué et état passant est ici assurée par chauffage dit « direct » en utilisant un circuit de commande DC doté d'électrodes de commande 3, 4 disposées de part et d'autre et en contact de la région de matériau PCM 5 auxquelles on applique des impulsions de courant.

Lorsque la région 5 est dans un état faiblement résistif le signal RF est transmis d'un élément conducteur 1 à l'autre élément conducteur 2, mais une partie du signal RF est susceptible de fuir vers le circuit de commande DC.

Dans le domaine des commutateurs à MEMS ou à transistors, il est connu de réaliser un découplage RF/DC en ajoutant une résistance fixe en série sur une ligne de commande du commutateur. Mais une telle solution appliquée aux commutateurs PCM nécessiterait d'augmenter de manière significative la tension de commande nécessaire pour faire commuter la région de matériau PCM.

Le document US 2014/0191181°A1 prévoit un commutateur RF à matériau PCM dans lequel le découplage RF/DC est mis en œuvre à l'aide d'inductances et de condensateurs. Un tel type de circuit de découplage a pour inconvénient d'être encombrant.

Le document US 2006/102927 divulgue un commutateur à base d'un matériau à changement de phase contrôlé par la polarité d'un signal de commande.

Le document US 2016/056373 divulgue un commutateur avec plusieurs régions à base d'un matériau à changement de phase.

Il se pose le problème de trouver une nouvelle structure de commutateur RF à matériau PCM amélioré vis-à-vis des inconvénients évoqués ci-dessus.

### EXPOSÉ DE L'INVENTION

Un but de la présente invention est de réaliser un commutateur RF à base de matériau PCM doté d'un moyen de découplage RF/DC d'encombrement réduit.

Le but énoncé ci-dessus est atteint par un commutateur RF apte à modifier une connexion entre un premier élément conducteur et un deuxième élément conducteur, cet élément commutateur étant adapté pour alternativement acheminer un signal RF et pour interrompre l'acheminement d'un signal RF entre le premier élément conducteur et le deuxième élément conducteur, le commutateur RF étant doté :
- d'une première région à base de matériau à changement de phase disposée entre le premier élément conducteur et le deuxième élément conducteur,
- de moyens de commande d'état de ladite première région de matériau à changement de phase configurés pour modifier par chauffage l'état cristallin ou amorphe dudit matériau à changement de phase de ladite première région, les moyens de commande étant dotés d'électrodes de commande agencées de part et d'autre de la première région et prévues pour appliquer un signal électrique de commande d'état de la première région de matériau à changement de phase,
le commutateur étant doté en outre d'un premier interrupteur de découplage configuré pour alternativement connecter une première électrode de commande et la première région de matériau à changement de phase lorsque ledit premier interrupteur de découplage est passant et pour déconnecter la première électrode de commande et la première région de matériau à changement de phase lorsque le premier interrupteur de découplage est bloqué, l'interrupteur de découplage comprenant une deuxième région de matériau à changement de phase disposée entre ladite première électrode de commande et une deuxième électrode de commande disposée contre la première région de matériau à changement de phase.

Le commutateur RF peut être doté de moyens de chauffage configurés pour placer le premier interrupteur de découplage alternativement dans un état passant et dans un état bloqué, les moyens de chauffage étant dotés d'électrodes agencées de part et d'autre de ladite deuxième région de matériau à changement de phase et prévues pour appliquer un signal électrique d'activation apte à modifier l'état cristallin ou amorphe dudit matériau à changement de phase de ladite deuxième région de matériau à changement de phase.

Selon une première possibilité de mise en œuvre du commutateur RF, les électrodes destinées à appliquer le signal électrique d'activation sont des électrodes de chauffage distinctes desdites électrodes de commande.

Selon une deuxième possibilité de mise en œuvre, le signal électrique d'activation est véhiculé par le biais de la première électrode de commande. La première électrode de commande remplit alors la fonction d'électrode de chauffage de la deuxième région PCM et d'électrode de commande de la première région PCM. Selon un mode de réalisation particulier, le premier élément conducteur est une ligne conductrice apte à véhiculer le signal RF d'un premier point vers un deuxième point d'un circuit RF, la première région de matériau à changement de phase formant une dérivation ou shunt commandé(e). Le deuxième élément conducteur sert alors de masse vers laquelle le signal RF peut être dérivé.

Selon une troisième possibilité de mise en œuvre, le signal électrique d'activation est véhiculé par la première électrode de commande et une électrode de chauffage distincte desdites première et deuxième électrodes de commande.

Selon une quatrième possibilité de mise en œuvre, les électrodes aptes à appliquer le signal électrique d'activation sont des électrodes de chauffage distinctes desdites première et deuxième électrodes de commande, la deuxième région de matériau PCM étant disposée entre la première électrode de commande et une deuxième électrode de commande en contact avec le premier élément conducteur.

Le commutateur RF peut être doté d'un deuxième interrupteur de découplage apte à alternativement connecter et déconnecter une autre électrode de commande et la première région de matériau à changement de phase, ledit deuxième interrupteur de découplage comprenant une autre région de matériau à changement de phase disposée entre ladite autre électrode de commande et ladite première région de matériau à changement de phase.

Dans ce cas, le commutateur RF peut être configuré pour alternativement passer d'un premier état à un deuxième état et inversement et pour passer du premier état du commutateur à un troisième état et inversement, et pour passer du troisième état à un quatrième état et inversement,
le premier état du commutateur étant tel que le premier interrupteur de découplage, le deuxième interrupteur de découplage sont passants tandis que le premier élément conducteur et le deuxième élément conducteur sont connectés l'un à l'autre,
le deuxième état du commutateur étant tel que le premier interrupteur de découplage, le deuxième interrupteur de découplage sont bloqués tandis que le premier élément conducteur et le deuxième élément conducteur sont connectés l'un à l'autre,
le troisième état du commutateur étant tel que le premier interrupteur de découplage, le deuxième interrupteur de découplage sont passants tandis que le premier élément conducteur et le deuxième élément conducteur sont déconnectés l'un de l'autre,
le quatrième état du commutateur étant tel le premier interrupteur de découplage, le deuxième interrupteur de découplage sont bloqués tandis que le premier élément conducteur et le deuxième élément conducteur sont déconnectés l'un de l'autre.

En variante, le commutateur RF peut être configuré pour alternativement passer d'un premier état à un deuxième état et inversement et pour passer du premier état du commutateur à un troisième état et inversement,
le premier état du commutateur étant tel que le premier interrupteur de découplage, le deuxième interrupteur de découplage sont passants tandis que le premier élément conducteur et le deuxième élément conducteur sont connectés l'un à l'autre,
le deuxième état du commutateur étant tel que le premier interrupteur de découplage, le deuxième interrupteur de découplage sont bloqués tandis que le premier élément conducteur et le deuxième élément conducteur sont connectés l'un à l'autre,
le troisième état du commutateur étant tel le premier interrupteur de découplage, le deuxième interrupteur de découplage sont bloqués tandis que le premier élément conducteur et le deuxième élément conducteur sont déconnectés l'un de l'autre.

On peut également prévoir au moins un troisième interrupteur de découplage en série avec le premier interrupteur de découplage, le troisième interrupteur de découplage comprenant une région de matériau à changement de phase.

Selon un agencement avantageux du commutateur RF, la première électrode de commande comporte des connexions distinctes en plusieurs points de la première région de matériau PCM, le premier élément conducteur ou la première électrode étant doté(e) d'une première portion conductrice disposée dans un premier plan parallèle à un plan principal du substrat, d'une deuxième portion conductrice disposée dans un deuxième plan parallèle au plan principal substrat et distinct du premier plan, et d'un via conducteur reliant la première portion conductrice de la deuxième portion conductrice, la première électrode de commande s'étendant entre le premier élément conducteur et le deuxième élément conducteur sans être en contact avec le premier élément conducteur ou le deuxième élément conducteur.

Selon une possibilité de mise en œuvre du commutateur RF, la première région de matériau à changement de phase peut être à base d'un premier matériau à changement de phase tandis que la deuxième région de matériau à changement de phase peut être à base d'un deuxième matériau à changement de phase différent du premier matériau à changement de phase.

Cela peut participer à la réalisation d'un contrôle indépendant entre l'interrupteur RF et le premier interrupteur de découplage.

Pour permettre un tel contrôle indépendant, on peut également prévoir de contrôler les changements d'état de la première région de matériau à changement par chauffage direct avec des électrodes directement en contact avec cette première région, tandis que les changements d'état de la deuxième région de matériau à changement sont contrôlés par chauffage indirect, des électrodes de chauffage permettant de contrôler ce changement d'état de la deuxième région étant situés à distance et isolées du matériau PCM de la deuxième région.

Pour permettre un contrôle indépendant des régions de matériau PCM on peut également adapter les géométries respectives de ces régions.

Ainsi, selon une possibilité de mise en œuvre, les moyens de chauffage sont dotés d'électrodes de chauffage agencées de part et d'autre de ladite deuxième région de matériau à changement de phase, la deuxième région de matériau à changement de phase ayant entre ses électrodes de chauffage une dimension X2 différente d'une autre dimension Y3 correspondant à la largeur des électrodes de chauffage en contact avec la deuxième région de matériau à changement de phase
Selon un mode de réalisation, la deuxième région de matériau à changement de phase a entre ses électrodes de chauffage une dimension X2 différente d'une dimension X3 correspondant à la largeur de la première électrode de commande et d'une autre électrode de commande en contact de la première région de matériau à changement de phase.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 sert à illustrer un exemple de commutateur RF mis en œuvre suivant l'art antérieur,
- la figure 2 sert à illustrer un exemple de commutateur RF suivant un mode de réalisation de la présente invention et doté d'interrupteurs de découplage DC/RF à matériau PCM,
- les figures 3A-3D servent à illustrer différents états de fonctionnement d'un commutateur RF,
- les figures 4A-4C servent à illustrer un exemple de réalisation du commutateur RF sur un substrat,
- les figures 5A-5H servent à illustrer un exemple de procédé de fabrication d'un commutateur RF à interrupteur de découplage DC/RF,
- la figure 6 sert à illustrer une variante de réalisation d'un commutateur RF réalisé sur un substrat et doté de régions de matériau à changement de phase disposées sous les électrodes de commande et/ou de chauffage associées,
- les figures 7A-7C servent à illustrer des variantes de réalisation pour lesquelles des électrodes de commande d'interrupteur RF et/ou de chauffage d'interrupteur de découplage sont agencées de sorte à réaliser un chauffage indirect des régions de matériau à changement de phase auxquelles elles sont associées,
- la figure 8 sert à illustrer un exemple de commutateur RF formé d'un interrupteur RF associé à un interrupteur de découplage DC/RF à matériau PCM dont l'état est contrôlé à l'aide d'électrodes servant également à contrôler l'état du matériau PCM de l'interrupteur RF,
- la figure 9 sert à illustrer un commutateur RF formé d'un ligne acheminant un signal RF alternativement connectée à, et déconnectée d'une dérivation en fonction de l'état d'une région de matériau PCM elle-même associée à un interrupteur de découplage,
- la figure 10 sert à illustrer un commutateur RF doté d'un interrupteur de découplage dont l'état est commandé par l'intermédiaire d'une électrode de chauffage et d'une électrode de commande servant également à commander l'état d'un interrupteur RF,
- la figure 11 sert à illustrer un commutateur RF doté d'un interrupteur RF et d'un interrupteur de découplage DC/RF, ces interrupteurs comportant des régions à base de matériaux PCM différents,
- la figure 12 sert à illustrer un commutateur RF avec plusieurs interrupteur de découplage en série,
- la figure 13 sert à illustrer un commutateur RF avec un interrupteur de découplage en série avec un interrupteur RF,
- la figure 14 sert à illustrer une variante de commutateur RF avec interrupteurs de découplage sans électrode de chauffage supplémentaire.

### EXPOSÉ DÉTAILLÉ DE MODES DE RÉALISATION PARTICULIERS

On se réfère tout d'abord au dispositif de la figure 2 illustrant de manière schématique un mode de réalisation d'un commutateur à matériau à changement de phase.

Ce commutateur permet de modifier une connexion entre au moins un premier élément conducteur 11 et au moins un deuxième élément conducteur 12. Dans cet exemple, les éléments conducteurs 11, 12 sont des éléments d'un circuit destiné à véhiculer des signaux radio-fréquences (RF).

Le commutateur est ainsi un commutateur RF apte à établir ou à interrompre une connexion entre une première portion de circuit et une deuxième portion de circuit en fonction de l'état d'au moins un matériau à changement de phase (PCM) agencé entre ces deux portions. Le commutateur permet, alternativement d'acheminer un signal RF et d'empêcher l'acheminement d'un signal RF entre les éléments conducteurs 11, 12.

Le premier élément conducteur 11 et le deuxième élément conducteur 12 forment dans cet exemple de réalisation deux terminaisons d'une ligne de transmission de signal électrique RF, ces deux terminaisons étant séparées l'une de l'autre par une première région 15 à base d'un matériau à changement de phase 20 et étant connectées électriquement à, et avantageusement en contact avec, ce matériau à changement de phase 20.

Le commutateur est susceptible d'adopter au moins un état dit « passant » dans lequel le premier élément conducteur 11 et le deuxième élément conducteur 12 sont connectés l'un à l'autre de sorte qu'au moins un signal RF peut transiter du premier élément conducteur 11 au deuxième élément conducteur 12. Le commutateur est également susceptible d'adopter au moins un état dit « bloqué » dans lequel, entre le premier élément conducteur 11 et le deuxième élément conducteur 12, la transmission d'un signal RF est empêchée.

Les états « passant » et « bloqué » du commutateur correspondent à différents états du matériau à changement de phase 20. Le matériau 20 à changement de phase est en particulier apte à passer d'un état amorphe à un état cristallin et inversement en fonction de la température à laquelle celui-ci est porté. Ainsi, ce matériau 20 à changement de phase intercalé entre les éléments conducteurs 11, 12 est susceptible, lorsqu'il est sous forme amorphe, d'adopter un état de forte résistivité, et lorsqu'il se trouve sous forme cristalline, d'adopter un état de faible résistivité. Par « faible résistivité » on entend une résistivité qui peut être comprise par exemple entre 10⁻⁴ ohm.cm et 10⁻² ohm.cm. Par « forte résistivité », on entend une résistivité qui peut être comprise par exemple entre 10 ohm.cm à 1000 ohm.cm.

Lorsque le matériau à changement de phase 20 est dans son état faiblement résistif (i.e. cristallin), un signal RF peut être ainsi transmis du premier élément conducteur 11 vers le deuxième élément conducteur 12 tandis que lorsque le matériau à changement de phase 20 est dans son état fortement résistif (i.e. amorphe), le signal RF parvenant au premier élément conducteur 11 est réfléchi et n'est donc pas transmis vers le deuxième élément conducteur 12.

Pour faire passer le matériau à changement de phase 20 d'un état cristallin à un état amorphe et inversement, le dispositif est doté de moyens de commande d'état du matériau PCM 20. Cette commande est ici mise en œuvre par chauffage, typiquement par effet joule, par exemple en injectant un courant électrique de commande directement dans le matériau PCM 20 de la première région 15.

Les moyens de commande d'état de la première région 15 de matériau PCM sont dotés d'une première électrode 13a de commande à laquelle le signal électrique de commande d'état de la première région 15 de matériau à changement de phase est destiné à être appliqué. Le signal de commande est typiquement un signal DC, en particulier un courant, délivré sous forme d'impulsions à courant continu.

Dans cet exemple, les moyens de commande sont également pourvus d'une autre électrode 14a de commande, la première région 15 de matériau à changement de phase étant disposée entre la première électrode 13a et cette autre électrode 14a de commande.

Pour passer d'un état cristallin à un état amorphe, le matériau à changement de phase 20 est chauffé à une température appartenant à une première gamme, de sorte à dépasser la température de fusion T_{F} du matériau 20. Les températures de la première gamme sont élevées et typiquement comprises entre 600°C et 1000°C. La température de fusion T_{F} est par exemple de l'ordre de 725°C pour du GeTe.

Le matériau à changement de phase 20 se refroidit rapidement pendant une durée comprise entre une dizaine et une centaine de nanosecondes de sorte que la recristallisation est évitée et que l'état amorphe est conservé.

Pour passer de l'état amorphe à l'état cristallin le matériau à changement de phase 20 est ensuite chauffé plus faiblement, à une température appartenant à une deuxième gamme. Les températures de la deuxième gamme sont inférieures à T_{F}. Par exemple, on chauffe à une température de l'ordre 150°C lorsque le matériau 20 est du GeTe. Le chauffage est alors prévu généralement selon une durée plus longue que lorsqu'on souhaite faire passer le matériau 20 de l'état cristallin à l'état amorphe. La durée du chauffage permettant la réorganisation du matériau 20 dans sa structure cristalline peut être par exemple prévu entre une microseconde et une dizaine de millisecondes.

L'impulsion de courant permettant de rendre amorphe peut avoir une intensité entre plusieurs centaines de micro-ampères et plusieurs dizaines de milli-ampères et dépend de la quantité de matériau PCM. On peut par exemple prévoir des impulsions de l'ordre de 1 mA et d'une durée de l'ordre de 10 µs pour effectuer une cristallisation, tandis que pour réaliser une amorphisation, les impulsions de courant ont une intensité plus importante, par exemple de l'ordre de 10 mA et une durée plus courte, par exemple de l'ordre de 50 ns.

Pour empêcher une transmission intempestive d'une partie du signal RF vers la ou les électrodes de commande 13a et/ou 14a lorsque le matériau à changement de phase 20 de la première région 15 est dans son état cristallin faiblement résistif, le dispositif a la particularité d'être doté de moyens de découplage.

Ces moyens de découplage sont dans l'exemple de la figure 2 sous forme d'interrupteurs INT1, INT2 de découplage disposés de part et d'autre de la première région 15. Les interrupteurs INT1, INT2 de découplage permettent alternativement de coupler et découpler les électrodes 13a et 14a respectivement de la première région 15 de matériau PCM. On met ainsi en œuvre un découplage commandé entre une partie DC et une partie RF du commutateur RF.

Un premier interrupteur INT1 de découplage est ainsi prévu pour, lorsqu'il est mis à l'état passant, coupler l'électrode de commande 13a et la première région 15 de matériau à changement de phase. Le signal électrique de commande DC peut alors être transmis de l'électrode 13a à la première région 15 de matériau à changement de phase.

Le premier interrupteur INT1 de découplage est également adapté pour, lorsqu'il est mis à l'état bloqué, découpler ladite électrode de commande 13a et la première région 15 de matériau à changement de phase. On empêche alors la transmission de signaux entre électrode 13a et région 15, et en particulier qu'une partie du signal RF de la première région 15 de matériau PCM ne se dirige vers l'électrode 13a.

Le premier interrupteur INT1 de découplage est lui-même formé d'une deuxième région 17 de matériau à changement de phase disposée entre l'électrode de commande 13a de la première région 15 de matériau à changement de phase de l'interrupteur RF 11-20-12.

Dans cet exemple de configuration particulier, l'interrupteur INT1 de découplage est également muni d'une deuxième électrode 13b de commande disposée contre une face de la deuxième région 17 de matériau PCM opposée à une autre face contre laquelle la première électrode 13a est agencée. La deuxième région 17 de matériau PCM de l'interrupteur de découplage est ainsi intercalée entre la première électrode de commande 13a et cette deuxième électrode de commande 13b.

Les changements d'état (passant à bloqué et inversement bloqué à passant) de l'interrupteur de découplage INT1 correspondant à des changements d'états (cristallin à état amorphe et inversement amorphe à cristallin) de la deuxième région 17 de matériau à changement de phase sont dans cet exemple contrôlés au moyen d'électrodes 16a, 16b dites « de chauffage » agencées de part et d'autre de la deuxième région 17 de matériau à changement de phase et distinctes des électrodes 13a, 13b de commande.

Pour chauffer le matériau PCM de la deuxième région 17 de l'interrupteur INT1 de découplage et le faire changer d'état on peut prévoir un chauffage direct dans lequel les électrodes 16a, 16b de chauffage sont disposées en contact avec le matériau PCM de la deuxième région 17. Le chauffage est typiquement obtenu par effet joule, en injectant un signal d'activation électrique, par exemple sous forme d'un courant dans le matériau PCM de la deuxième région 17. Le signal d'activation est typiquement un signal DC, en particulier un courant, délivré sous forme d'impulsions à courant continu.

Lorsqu'une impulsion de courant appropriée passe entre les deux électrodes 16a et 16b à travers le matériau PCM de la deuxième région 17, ce matériau passe d'un état cristallin à un état amorphe fortement résistif. On bloque alors le passage d'un signal entre l'électrode 13b et l'électrode 13a. Pour faire passer le matériau PCM de son état amorphe à son état cristallin, on applique une autre impulsion de courant appropriée entre les deux électrodes 16a, 16b à travers la deuxième région 17 de matériau PCM.

L'impulsion de courant permettant de rendre amorphe le matériau PCM de la deuxième région 17 peut avoir une intensité entre plusieurs centaines de micro-ampères et plusieurs dizaines de milli-ampères suivant la quantité de matériau PCM. On peut par exemple prévoir des impulsions de l'ordre de 1 mA et d'une durée de l'ordre de 10 µs pour effectuer une cristallisation, tandis que pour obtenir une amorphisation, les impulsions de courant ont une intensité plus importante, par exemple de l'ordre de 10 mA et une durée plus courte, par exemple de l'ordre de 50 ns.

Un deuxième interrupteur INT2 de découplage est également prévu pour alternativement coupler et découpler une deuxième électrode de commande 14a des moyens de commande et la première région 15 de matériau à changement de phase. Le deuxième interrupteur INT2 de découplage est également adapté pour, lorsqu'il est à l'état bloqué, découpler l'autre électrode de commande 14a de la première région 15 de matériau à changement de phase. On empêche alors qu'une partie du signal RF ne soit transmise vers l'autre électrode de commande 14a lorsque la première région 15 de matériau à changement de phase est dans un état de faible résistivité.

Le deuxième interrupteur INT2 de découplage est lui-même doté d'une troisième région 19 de matériau à changement de phase autour de laquelle l'autre électrode de commande 14a, une électrode de commande 14b, une électrode de chauffage 18a, et une autre électrode de chauffage 18 sont réparties.

Le passage alternativement, de l'état bloqué à l'état passant et de passant à bloqué de l'interrupteur de découplage INT2 est contrôlé par les électrodes 18a, 18b de chauffage disposées contre des faces opposées de la troisième région 19 de matériau PCM.

Dans cet exemple de réalisation, les électrodes 14a, 14b de commande situées contre des faces opposées de la troisième région 19 de matériau PCM différentes des faces contre lesquelles les électrodes 18a, 18b de chauffage sont agencées. Dans cette configuration les électrodes 14a, 14b de commande sont distinctes des électrodes 18a, 18b de chauffage et ne se sont pas en contact avec ces dernières.

Ainsi, dans l'exemple de dispositif qui vient d'être décrit, les interrupteurs INT1, INT2 de découplage sont équivalents à des résistances variables bistables avantageusement de structure similaire à celle de l'interrupteur RF.

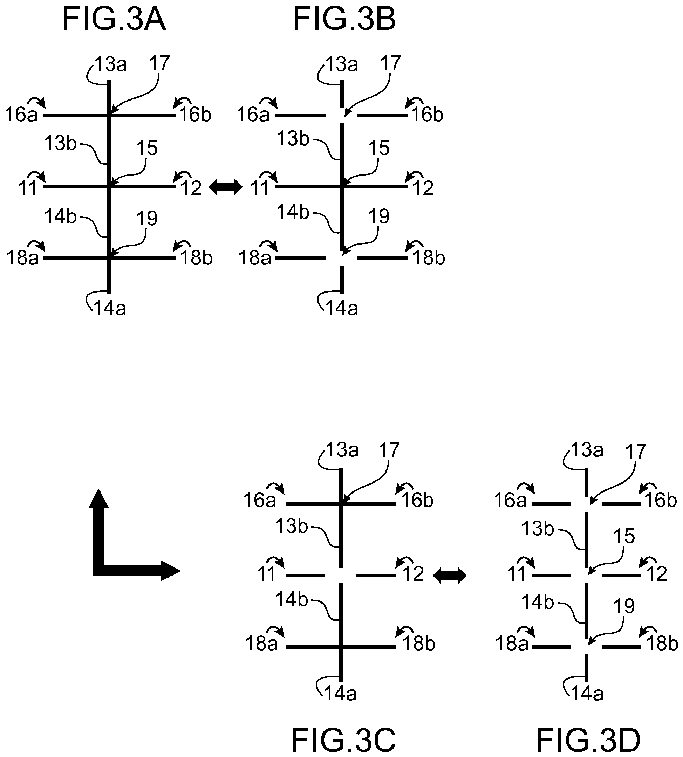

Différents états de fonctionnement d'un dispositif tel que précédemment décrit sont illustrés sur les figures 3A-3D.

Dans un premier état illustré sur la figure 3A, les régions 15, 17, 19 de matériau PCM sont chacune dans une phase cristalline faiblement résistive. Une partie d'un signal RF destiné à traverser la région 15 de matériau PCM est alors susceptible de fuir vers les électrodes 13a et 14a.

Un courant d'activation est injecté entre les électrodes 16a et 16b et entre les électrodes 18a et 18b pour faire passer respectivement les deuxième et troisième régions 17 et 19 de matériau PCM dans une phase amorphe fortement résistive. Le dispositif se trouve alors dans un deuxième état tel qu'illustré sur la figure 3B. Les régions 17 et 19 de matériau PCM étant dans des phases amorphes fortement résistives, on évite une fuite d'une partie du signal RF vers les électrodes 13a et 14a de commande. Cet état correspond à l'état passant souhaité de l'interrupteur RF.

Ensuite, on cherche à bloquer la transmission de signal RF entre le premier élément conducteur 11 et le deuxième élément conducteur 12. Pour cela, on modifie l'état de la première région 15 de matériau PCM en injectant un courant de commande entre les électrodes de commande 13a et 14a.

Pour permettre à ce courant de commande de circuler, les deuxième région 17 et troisième région 19 de matériau PCM sont tout d'abord mises dans un état faiblement résistif. On injecte pour cela un courant d'activation entre les électrodes de chauffage 16a et 16b et entre les électrodes de chauffage 18a et 18b afin de faire passer respectivement les deuxième région 17 et troisième région 19 de matériau PCM dans une phase cristalline. On se retrouve ainsi à nouveau dans un état tel que décrit précédemment et illustré sur la figure 3A.

A partir de ce premier état, on injecte un autre courant de commande entre les électrodes 13a et 14a de commande, de sorte à faire passer la première région 15 de matériau PCM dans une phase amorphe fortement résistive sans modifier l'état des régions 17 et 19 de matériau PCM. La transmission de signal RF est alors bloquée entre le premier élément conducteur 11 et le deuxième élément conducteur 12. Cet état bloqué de l'interrupteur RF est illustré sur la figure 3C.

A partir de cet état on peut injecter un autre courant d'activation entre les électrodes 16a et 16b et entre les électrodes 18a et 18b pour faire passer respectivement les régions 17 et 19 de matériau PCM dans une phase amorphe fortement résistive. On se retrouve alors dans un état tel qu'illustré sur la figure 3D, dans lequel chacune des régions 15, 17, 19 se trouve dans une phase amorphe fortement résistive.

Puis, on peut injecter ensuite un courant d'activation entre les électrodes 16a et 16b et entre les électrodes 18a et 18b pour faire passer respectivement les régions 17 et 19 de matériau PCM dans une phase cristalline faiblement résistive et pour revenir dans un état tel qu'illustré sur la figure 3C avant d'injecter un signal électrique d'activation entre les électrodes 13a et 14a, sans dissipation dans les régions de matériau PCM 17 et 19, pour faire passer la première région 15 de matériau PCM dans une phase cristalline faiblement résistive et se retrouver ainsi à nouveau dans un état tel qu'illustré sur la figure 3A.

Pour permettre de modifier l'état de la région centrale 15 et en particulier de mettre à l'état amorphe sans modifier l'état cristallin de l'une des régions 17 ou 19 voire d'aucune des régions 17, 19, on peut prévoir ces régions 17, 19 à base d'un matériau PCM différent de celui de la région centrale 15. On peut également prévoir un contrôle des régions 17, 19 par chauffage indirect autrement dit sans contact direct des électrodes 16a, 16b, 18a, 18b avec le matériau PCM des régions 17, 19, les électrodes pouvant être en contact avec un matériau résistif intermédiaire. Ainsi, la région centrale 15 peut être à base d'un premier matériau PCM tel que le GeTe apte à être contrôlé par chauffage direct, c'est-à-dire avec un contact direct des électrodes sur le matériau PCM et les régions 17 et 19 à base d'un deuxième matériau PCM différent du premier matériau, tel que le VO₂ dont l'état amorphe ou cristallin est apte à être contrôlé par chauffage indirect. Ces deux matériaux ont également des températures de transition différentes.

Un courant qui circule entre l'électrode 16a et l'électrode 16b au travers d'un matériau résistif intermédiaire placé au-dessus d'une région 17 en VO₂ est susceptible de produire un dégagement de chaleur qui, par effet joule, permet de chauffer le matériau de cette région 17 en VO₂ au-dessus de sa température de transition pour le rendre conducteur.

On maintient le courant entre les électrodes 16a et 16b pour conserver l'état conducteur du matériau de la région 17.

Une coupure du courant entre les électrodes 16a et 16b est susceptible de rendre le matériau de la région 17 isolant. Le passage du courant de commande de la région centrale 15 au travers du matériau de la région 17 lorsqu'il est conducteur ne modifie pas son état.

Un exemple de fonctionnement d'une telle configuration va à présent être décrit.

On part, par exemple, d'un état initial tel qu'illustré 3B.

On applique ensuite un courant entre les électrodes 16a, 16b et entre les électrodes 18a, 18b tel que le VO₂ chauffe et devienne conducteur. On passe alors dans un état tel qu'illustré sur la figure 3A.

Le courant est maintenu entre électrodes 16a, 16b et entre les électrodes 18a, 18b et l'on applique un courant entre les électrodes 13a et 14a de sorte à garder conducteur le matériau VO₂ des régions 17, 19 et rendre amorphe le matériau GeTe de la région centrale 15. On passe alors dans un état tel qu'illustré sur la figure 3C.

On coupe ensuite le courant entre les électrodes 16a, 16b et entre les électrodes 18a,18b de sorte à rendre le matériau VO₂ des régions 17, 19 isolant et à passer dans un état tel que sur la figure 3D. Puis, on applique à nouveau un courant entre les électrodes 16a, 16b et 18a, 18b ce qui fait chauffer le matériau VO₂ des régions 17, 19 et les rend conductrices. On passe alors dans un état tel qu'illustré sur la figure 3C.

Si l'on maintient un courant entre les électrodes 16a, 16b et entre les électrodes 18a, 18b et que l'on applique un courant dit « de cristallisation » entre les électrodes 13a et 14a, le matériau VO₂ des régions 17, 19 reste conducteur tandis que le matériau GeTe de la régions 15 devient cristallin. On repasse alors dans un état tel qu'illustré sur la figure 3A.

Si l'on coupe le courant entre les électrodes 16a, 16b et entre les électrodes 18a, 18b, le matériau VO₂ des régions 17, 19 redevient alors isolant et l'on repasse dans un état tel qu'illustré sur la figure 3B.

En variante, on peut prévoir une autre configuration avec des régions 15, 17 et 19 à base d'un même matériau PCM, par exemple du GeTe. Dans ce cas, on prévoit alors des géométries et/ou des dimensions respectives adaptées des régions 15, 17 et/ou 19 afin de pouvoir réaliser une commutation indépendante de l'interrupteur RF et du ou des interrupteurs de découplage.

Un exemple de fonctionnement de cette autre configuration est le suivant : A partir d'un premier état tel qu'illustré sur la figure 3A, on applique un courant d'amorphisation entre les électrodes de chauffage 16a et 16b et entre les électrodes de chauffage 18a, 18b. Par exemple le courant d'amorphisation appliqué est de l'ordre de 10mA pendant une durée de 50 ns. Les régions 17 et 19 deviennent alors amorphes. Si les régions 17 et 19 sont commandées par chauffage indirect aucun courant ne traverse alors la région 15 et le matériau PCM de cette région 15 reste cristallin. Dans le cas d'un chauffage direct des régions 17 et 19, la configuration du circuit peut être prévue telle que ce courant sera suffisamment faible, en particulier très inférieur à 10 mA, pour ne pas modifier l'état de la région 15 et que le matériau PCM de celle-ci reste cristallin. L'état devenu amorphe du matériau PCM des régions 17, 19 est illustré sur la figure 3B. Lorsqu'on applique à présent un courant de cristallisation entre les électrodes de chauffage 16a, 16b et un courant de cristallisation entre les électrodes de chauffage 18a, 18b, les régions 17 et 19 redeviennent dans un état cristallin. La région 15, reste alors quant à elle sous forme cristalline. On repasse ainsi dans l'état illustré sur la figure 3A.

Si l'on applique à présent un courant d'amorphisation entre les électrodes de commande 13a et 14a par exemple de l'ordre de 10 mA selon une durée de l'ordre de 50ns, le courant traverse les régions 17, 15 et 19 et la région 15 est rendue amorphe. L'intensité du courant d'amorphisation est typiquement proportionnelle à la largeur de matériau PCM traversée. Si l'on prévoit les régions 17 et 19 avec une dimension mesurée entre les électrodes 13a, 13b et entre les électrodes 14a, 14b plus large qu'une dimension de la région 15 mesurée entre les électrodes 13b, 14b alors le courant pour rendre amorphe la région 15 est plus important que pour rendre amorphe les régions 17 et 19. On peut donc avoir un passage de la région 15 dans l'état amorphe tandis que les régions 17, 19 sont maintenues dans un état cristallin. On se trouve alors dans un état tel qu'illustré sur la figure 3C.

A partir de cet état, on peut appliquer un courant d'amorphisation entre les électrodes de chauffage 16a, 16b et entre les électrodes de chauffage 18a, 18b de sorte que les régions 17 et 19 deviennent amorphes. On passe alors dans l'état illustré sur la figure 3D. A partir de cet état, si l'on applique un courant de cristallisation entre les électrodes de chauffage 16a et 16b et entre les électrodes de chauffage 18a, 18b, les régions 17 et 19 redeviennent dans un état cristallin et l'on repasse dans l'état illustré sur la figure 3C.

A partir de cet état, si on applique un courant de cristallisation entre les électrodes de commande 13a et 14a de 1mA selon une durée de 10 µs, alors ce courant traverse les régions 17,15 et 19 et la région 15 redevient dans un état cristallin, tandis que les régions 17 et 19 restent dans un état cristallin. On repasse alors dans l'état illustré sur la figure 3A.

Un autre mode de mise en œuvre prévoit de pouvoir passer directement d'un état tel qu'illustré sur la figure 3A à un état tel qu'illustré sur la figure 3D (passage symbolisé par une double flèche en trait discontinu). C'est le cas si l'on prévoit des dimensions des régions 17, 19 mesurées respectivement entre les électrodes 13a, 13b et 14a, 14b, cette fois moins larges qu'une dimension de la région 15 mesurée entre les électrodes 13b, 14b. C'est également le cas si l'on prévoit un courant d'amorphisation suffisamment important en termes d'intensité et de durée pour rendre amorphe les régions 17, 15, 19. Par exemple, si les régions 17 et 19 ont une largeur de 1 µm et qu'un courant de l'ordre de 10 mA est nécessaire pour les rendre amorphe et si la région 15 a une largeur de 2 µm, on peut prévoir un courant de 20 mA pour passer directement de l'état de la figure 3A à celui de la figure 3D.

De même, on peut également passer directement d'un état tel qu'illustré sur la figure 3D à un état tel qu'illustré sur la figure 3A.

Un commutateur tel que décrit précédemment peut être réalisé en couches minces sur un substrat.

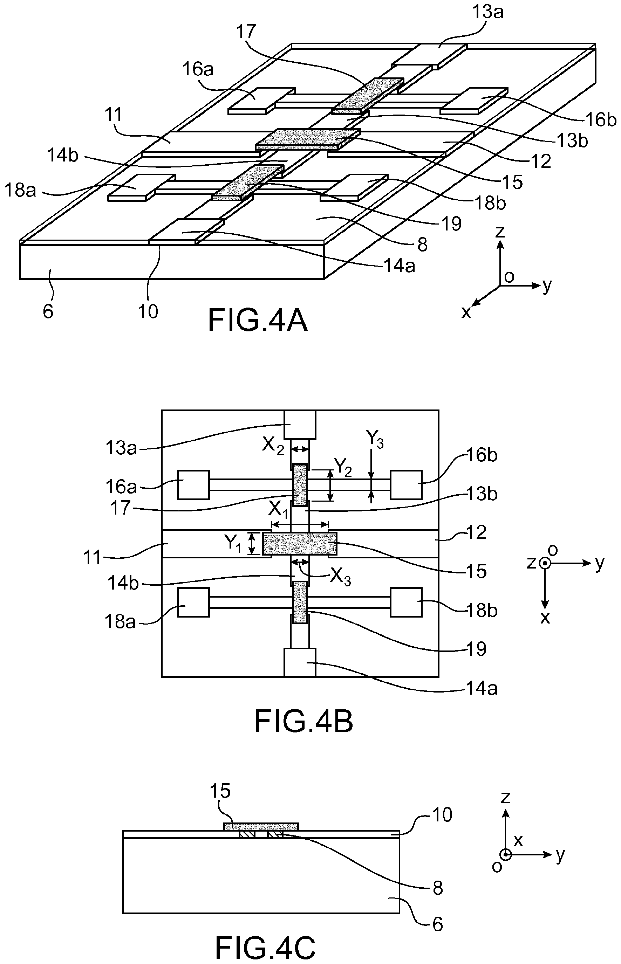

Les figures 4A-4C illustrent (par le biais respectivement d'une vue en perspective, d'une vue de dessus, et d'une vue en coupe transversale) un exemple d'intégration d'un commutateur RF à matériau PCM et système de découplage RF/DC sur un substrat 6 qui peut être semi-conducteur et par exemple en silicium.

Le commutateur peut être disposé sur une couche isolante 8 de passivation du substrat 6 ou une couche isolante 8 par exemple de type IMD pour (« Intermetal Dielectric Layer ») et qui est située entre deux niveaux d'interconnexions de composants électroniques ou bien une couche isolante appartenant à un des niveaux finaux communément appelés de « back-end » d'un circuit intégré.

Les éléments conducteurs 11, 12, et électrodes 13a, 13b, 14a, 14b, 16a, 16b et 18a, 18b sont formés par exemple à partir d'une couche conductrice 10 qui peut être, par exemple, à base d'un métal pur tel que l'Aluminium (Al), le cuivre (Cu), l'or (Au), le titane (Ti), l'argent (Ag) ou le Tungstène (W) ou d'un alliage métallique tel que de l'AICu, ou de l'AISi. D'autres matériaux conducteurs comme par exemple des semiconducteurs dopés, en particulier du silicium dopé, des oxydes métalliques tels que par exemple de l'oxyde de ruthénium (RuO₂), de l'Oxyde d'iridium (IrO₂) peuvent être également utilisés. Avantageusement les éléments conducteurs 11, 12, et électrodes 13a, 13b, 14a, 14b de commande sont à base de matériau conducteur transparent tel que par exemple de l'oxyde conducteur ITO (pour « Indium tin oxide ») ou du polymère conducteur comme le PEDOT (3,4-éthylènedioxythiophène). Le dépôt de la couche conductrice est réalisé par exemple par une méthode PVD (pour « Physical Vapor Deposition »). Plusieurs matériaux conducteurs empilés peuvent être utilisés pour former les éléments conducteurs et électrodes.

Dans l'exemple des figures 4A-4C, les éléments conducteurs et électrodes sont à base d'un même matériau conducteur. En variante, les éléments conducteurs peuvent être réalisés à l'aide de matériau conducteur différent de celui ou de ceux utilisé(s) pour réaliser les électrodes de chauffage et de commande.

La couche isolante 8 sur laquelle les éléments 11, 12 et électrodes sont disposées peut, quant à elle, être par exemple à base de dioxyde de silicium SiO₂, ou de SiN, ou d'AIN, ou d'Al₂O₃.

Le (ou les) matériau(x) à changement de phase des régions 15, 17 et 19 peut (ou peuvent) être à base de chalcogénure ou d'un alliage de chalchogénures comme du Ge₂Sb₂Te₅ ou du GeTe. Le GeTe permet par exemple d'obtenir une modulation de résistance de 10⁴ à 10⁶ suite à un échauffement rapide et contrôlé du matériau. Cette modification est due au changement rapide et réversible entre une phase hautement résistive (pour laquelle la conductivité typiquement de l'ordre de 10 S/m à 1 S/m pour la phase amorphe du GeTe) et une phase faiblement résistive (où la conductivité est typiquement de l'ordre de 100 kS/m à 1 MS/m pour la phase cristalline du GeTe). Comme dans les exemples de réalisation décrits précédemment, les régions 15, 17, 19 peuvent être à base du même matériau PCM ou bien formées de matériaux PCM différents.

Les dimensions de la première région 15 de matériau PCM sont typiquement prévues de sorte à avoir une résistance à l'état passant de l'ordre de 1 Ohm afin de permettre une bonne transmission du signal RF. On peut prévoir par exemple pour cela une région 15 de GeTe de forme parallélépipédique de longueur X1 par exemple de l'ordre de 1 µm entre les éléments conducteurs 11 et 12, une largeur Y1 par exemple de l'ordre de 30 µm entre les électrodes 13b, 14b et une épaisseur par exemple de l'ordre de 100 nm pour un matériau de conductivité de 300 kS/m.

Les dimensions des régions 17 et 19 sont définies en fonction des valeurs de résistances souhaitées. Lorsque ces régions 17, 19 sont en GeTe, une résistance variable de 30 ohms à 1 Méga-ohms par exemple peut être obtenue en prévoyant ces régions sous forme de bandes parallélépipédiques de longueur de 1 µm, de largeur de 1 µm et d'épaisseur de 100 nm. Ainsi, on peut avantageusement réaliser des interrupteurs de découplage de faibles dimensions.

Les régions 15, 17 et 19 de matériau PCM peuvent être prévues avec des dimensions telles qu'une section transversale d'un volume de matériau PCM de la deuxième région 17 séparant les électrodes de chauffage 16a, 16b (ou de la troisième région 19 séparant les électrodes de chauffage 18a, 18b) est plus faible qu'une section transversale d'un volume de la première région 15 de matériau PCM séparant les électrodes de commande 13b, 14b. La section transversale est mesurée parallèlement à l'axe z d'un repère orthogonal [0 ;x ;y ;z] défini sur les figures 4A-4C.

Dans l'exemple illustré sur la figure 4B, on prévoit des régions 17, 19 de dimension X2 entre les éléments électrodes de chauffage 16a, 16b (resp. 18a, 18b) supérieure à une autre dimension Y3 correspondant à la largeur des électrodes de chauffage 16a,16b (resp. 18a, 18b) en contact avec la région 17 (resp.19). Avec une telle géométrie, on peut obtenir un changement de phase d'une région 17 lorsqu'un premier courant entre les électrodes 16a, 16b de chauffage traverse cette région 17 sans pour autant qu'un courant de même intensité entre les électrodes de commande 13a, 13b ne génère nécessairement un changement de phase correspondant dans la région 17. Dans cet exemple, la dimension X2 de la région 17 mesurée entre les électrodes de commande 13a, 13b est également prévue supérieure à celle X3 correspondant à la largeur des électrodes des électrodes 13b, 14b en contact avec la région 15. Cela participe à l'établissement d'une commande indépendante entre interrupteurs de découplage et interrupteur RF.

Ainsi, l'énergie nécessaire pour faire changer de phase les régions 17, 19 sera plus faible que pour faire changer de phase la première région 15. Les régions 17, 19 sont prévues en termes de composition et de dimensions de sorte à avoir une résistance prévue suffisamment faible pour ne pas s'opposer au passage du courant au moment de faire changer la phase de la première région de matériau PCM 15 et une résistance suffisamment élevée à l'état bloqué par exemple de l'ordre de 1 MΩ pour permettre un découplage BF/RF efficace.

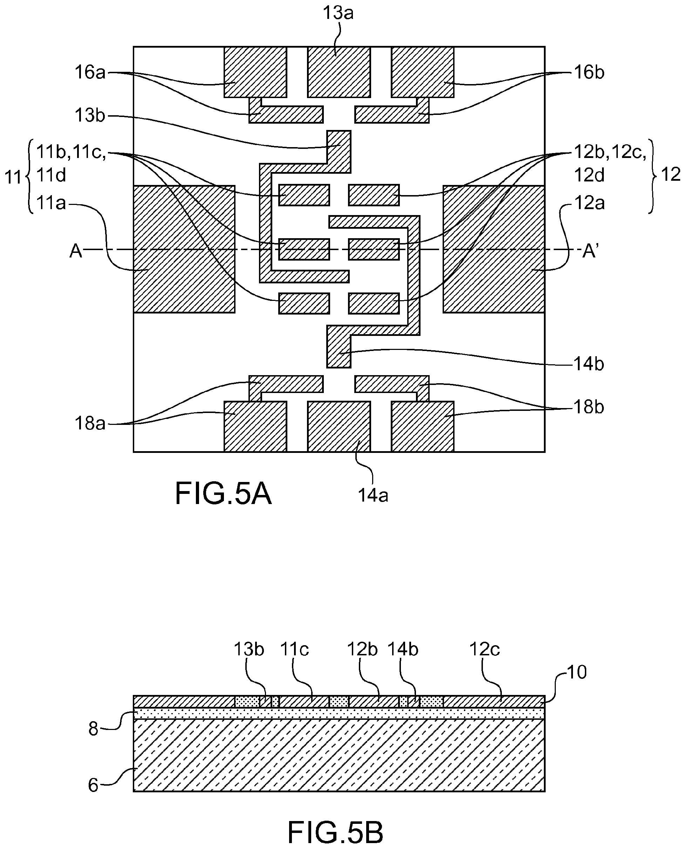

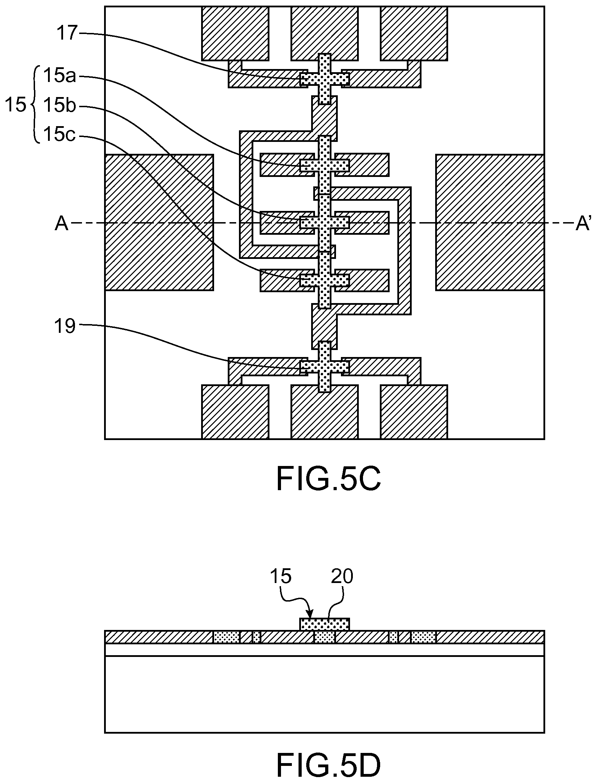

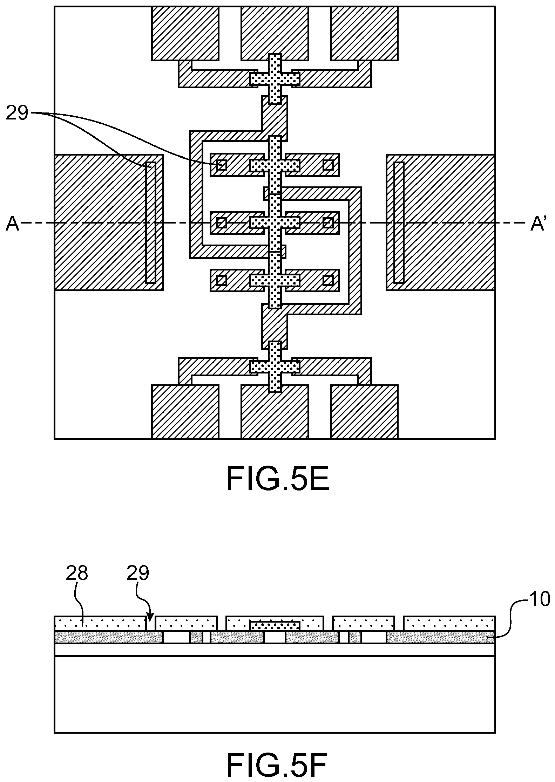

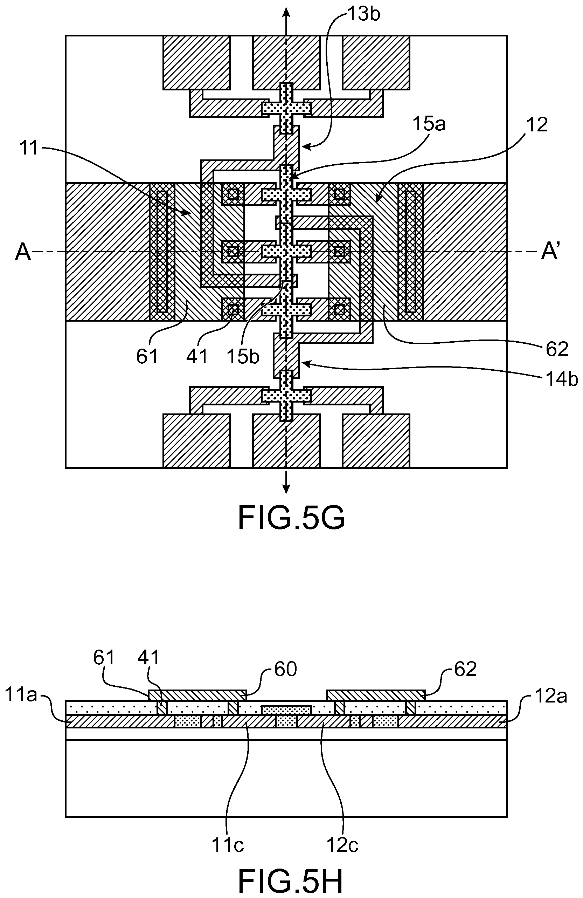

Un exemple de procédé de fabrication d'un commutateur RF à système de découplage DC/RF va à présent être donné en liaison avec les figures 5A-5H.

Le support de départ de ce procédé est un substrat 6, par exemple en silicium recouvert par une couche isolante 8 par exemple en SiO₂ (dioxyde de silicium) et d'épaisseur qui peut être par exemple de l'ordre de 500 nm.

Sur cette couche isolante 8, on dépose tout d'abord une couche conductrice 10 dans laquelle on réalise des motifs par exemple par photolithographie et gravure. Cette couche conductrice 10 est typiquement formée d'un empilement de plusieurs matériaux conducteurs, par exemple d'une couche à base de Ti d'épaisseur de l'ordre de 10 nm, d'une couche à base de TiN d'épaisseur de l'ordre de 40 nm, d'une couche d'AICu d'épaisseur de l'ordre de 440 nm, d'une couche de Ti d'épaisseur de l'ordre de 10 nm et d'une couche à base de TiN d'épaisseur de l'ordre de 100 nm. Le dépôt peut être effectué par une technique de PVD. La structuration de la couche conductrice 10 est effectuée de manière à définir en partie les motifs des éléments conducteurs 11, 12, des électrodes de commande 13a, 13b, 14a, 14b, des électrodes de chauffage 16a, 16b, 18a, 18b.

Dans l'exemple particulier illustré sur les figures 5A-5B (donnant respectivement une vue de dessus et une vue en coupe transversale selon un axe AA'), les éléments conducteurs 11, 12 entre lesquels le signal RF est destiné à transiter sont formés de plusieurs portions conductrices 11a, 11b, 11c, 11d, 12a, 12b, 12c, 12d, disjointes. Les éléments conducteurs 11, 12 peuvent être formés en particulier de portions 11a, 12a principales sous forme de plots occupant une surface (mesurée parallèlement au plan principal du substrat) donnée et de plusieurs portions 11b, 11c, 11d, 12b, 12c, 12d, secondaires sous forme de bandes conductrices parallèles disposées entre les plots 11a, 12a et de taille en termes de surface occupée sur le substrat inférieure à celle des plots.

Les électrodes de commande 13b, 14b s'étendent dans cet exemple entre les éléments conducteurs 11, 12.

Un dépôt de matériau isolant par exemple du SiO₂ d'épaisseur par exemple de l'ordre de 700 nm est ensuite réalisé à l'aide par exemple d'un plasma de type HDPCVD pour (« High Density Plasma Chemical Vapor Deposition »). Puis, par exemple par CMP (« Chemical mechanical polishing »), on effectue une planarisation de sorte à atteindre et dévoiler la face supérieure des portions conductrices.

Puis, un matériau à changement de phase 20, tel que du GeTe par exemple d'épaisseur de l'ordre 100nm, est déposé par exemple par PVD. On réalise ensuite des motifs dans ce matériau 20 de sorte à former la première région 15 de matériau PCM pour l'interrupteur RF et les deuxième et troisième régions 17, 19 de matériau PCM pour les interrupteurs de découplage. Les motifs de matériau PCM 20 sont structurés typiquement par photolithographie et gravure, par exemple de type IBE (pour « Ion Beam Etching »).

Dans l'exemple de réalisation illustré sur les figures 5C-5D, la première région 15 de matériau PCM est structurée sous forme de parcelles 15a, 15b, 15c alignées chacune en forme de croix dont les extrémités des branches reposent sur les portions conductrices des éléments conducteurs 11, 12 et des électrodes de commande 13b, 14b.

Les régions 17, 19 de matériau PCM réalisent des motifs en forme de croix dont les extrémités des branches reposent sur des portions conductrices d'électrodes de chauffage et d'électrodes de commande.

Le matériau à changement de phase 20 est ensuite passivé par dépôt d'un matériau diélectrique 28 tel que du SiN d'épaisseur par exemple de l'ordre de 100 nm et qui peut être formé à l'aide d'une technique de PECVD (pour « Plasma Enhanced Chemical Vapor deposition »).

Des éléments de connexion verticaux encore appelés « vias » 41 sont ensuite formés dans ce matériau diélectrique 28. Pour cela, on réalise tout d'abord, et comme cela est illustré par exemple sur les figures 5E-5F, des ouvertures 29 par exemple par photolithographie et gravure. Une gravure ionique réactive (RIE pour « reactive ion etching ») peut être en particulier utilisée. Les ouvertures 29 dévoilent des zones de contact de portions de la couche conductrice 10 dans laquelle éléments conducteurs et électrodes son formées.

Un deuxième niveau conducteur 60 est ensuite déposé, par exemple par PVD, afin de compléter la formation des éléments conducteurs 11 et 12. Le deuxième niveau conducteur 60 peut être formé d'un empilement comprenant par exemple une couche de Ti de l'ordre de 10 nm, une couche de TiN qui peut être de l'ordre de 40 nm, une couche d'AICu par exemple de l'ordre de 900 nm, une couche de Ti par exemple de l'ordre de 10 nm et une couche de TiN par exemple de l'ordre de 40 nm.

On réalise ensuite des portions conductrices 61, 62 dans ce deuxième niveau conducteur qui est ensuite structuré par photolithographie et gravure. Ces portions conductrices 61, 62 sont connectées respectivement aux portions conductrices 11a, 11b, 11c, 11d, et aux portions conductrices 12a, 12b, 12c, 12d du premier niveau conducteur par l'intermédiaire de vias 41.

Une répartition des éléments conducteurs 11, 12 en portions conductrices disposées sur plusieurs niveaux conducteurs permet de réaliser un agencement tel qu'illustré sur les figures 5G-5H dans lequel des portions d'une électrode de commande 13b passent en regard de zones d'un élément conducteur 11 du deuxième niveau conducteur.

Un tel agencement permet de connecter une électrode de commande 13b en plusieurs points de la première région de matériau 15 PCM. Les électrodes de commande 13b, 14b peuvent en particulier être connectées à la première région 15 de matériau PCM en plusieurs points distincts dans une zone qui est située entre les éléments conducteurs 11, 12, et ce sans entrer en contact avec ces éléments conducteurs 11, 12.

Dans cette zone, la première région 15 de matériau PCM est alternativement connectée à une portion conductrice d'élément conducteur 11 ou 12 et à une portion conductrice d'électrode de commande 13b ou 14b.

Une connexion des électrodes de commande 13b, 14b en plusieurs points distincts 15a, 15b de la première région 15 de matériau PCM répartis le long de cette dernière peut permettre un meilleur contrôle des états amorphe et cristallin de cette première région 15.

En variante de l'agencement qui vient d'être décrit, on peut prévoir de réaliser les électrodes de commande sur plusieurs niveaux avec au moins une portion conductrice disposée dans un premier plan parallèle à un plan principal du substrat, une deuxième portion conductrice disposée dans un deuxième plan parallèle au plan principal du substrat et distinct du premier plan, et d'un via conducteur reliant la première portion conductrice de la deuxième portion conductrice, ce afin de pouvoir faire passer l'électrode de commande entre les éléments conducteurs RF 11, 12 et réaliser une connexion en plusieurs points de la première région 15 de matériau PCM.

Dans l'exemple de procédé qui vient d'être décrit, le matériau PCM des régions 15, 17, 19 est situé entre deux niveaux conducteurs 10, 60 dans lequel les éléments conducteurs 11, 12 sont formés.

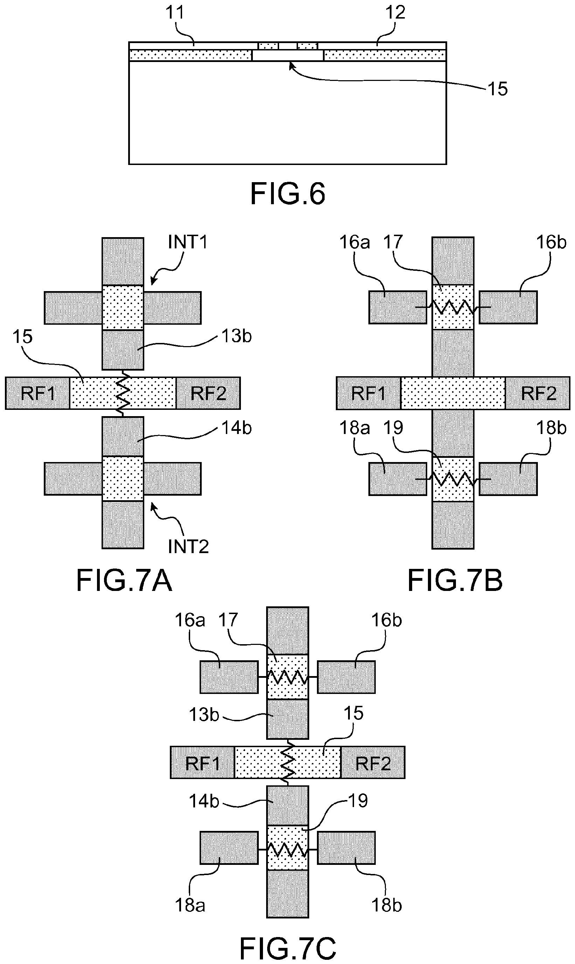

Une autre répartition du matériau PCM et des niveaux conducteurs est possible. Ainsi, selon un autre exemple de configuration illustré sur la figure 6 des régions 15, 17, 19 de matériau PCM sont disposées sous les niveaux conducteurs 10, 62 dans lesquels les éléments conducteurs 11, 12, les électrodes de commande 13a, 14a, 13b, 14b, et électrodes de chauffage sont formées. Pour former un tel dispositif, on dépose typiquement le matériau PCM avant de réaliser le ou les niveaux métalliques des électrodes. Un premier avantage est que le matériau PCM peut être déposé dans un premier environnement de type salle blanche respectant certaines règles en matière de contamination propres aux procédés de type BEOL (pour « Back-end of line ») de la microélectronique et que l'on peut ensuite réaliser les niveaux métalliques dans un autre environnement, par exemple propice au dépôt de métal noble. Un autre avantage d'une telle configuration est que certains matériaux PCM peuvent nécessiter des recuits à hautes températures typiquement supérieures à 600°C après l'étape de dépôt, alors que de telles températures peuvent s'avérer trop élevée pour certains métaux.

Comme cela a été vu précédemment, l'état de la première région 15 de matériau PCM peut être modulé par chauffage direct, c'est-à-dire avec un échauffement obtenu en faisant passer un courant appliqué par le biais d'électrodes 13b, 14b disposées directement en contact avec le matériau PCM.

Il est également possible de mettre en œuvre un changement de phase ou d'état des régions 15, 17, 19 par un chauffage indirect grâce à des radiations/conduction thermiques produites par une source de chaleur déportée qui n'est pas en contact avec le matériau à changement de phase.

Un tel type de chauffage indirect est illustré par exemple sur la figure 7A. Le commutateur RF est dans cet exemple muni d'électrodes de commande 13b, 14b situées de part et d'autre de la première région 15 de matériau PCM mais cette fois à distance de cette dernière, sans être en contact avec cette première région 15. Un espace de séparation entre région 15 et électrodes 13a, 13b peut être prévu de l'ordre de plusieurs dizaines de nm, par exemple de 100 nm. Cet espace peut être occupé par un matériau isolant électrique et de préférence conducteur thermique tel que par exemple du SiN ou de l'AIN.

Une variante illustrée sur la figure 7B, prévoit cette fois de contrôler le changement d'état des interrupteurs de découplage INT1, INT2 par chauffage indirect. Les électrodes de chauffage 16a, 16b, 18a, 18b permettant de moduler la résistivité des régions 17, 19 de matériau PCM des interrupteurs de découplage sont ainsi situées à distance de ces régions 17, 19.

Dans le commutateur RF illustré sur la figure 7C, ce sont à la fois les régions 17, 19 des interrupteurs de découplage et la région 15 centrale de matériau PCM dont l'état est commandé par chauffage indirect. Les électrodes de chauffage 16a, 16b, 18a, 18b et les électrodes de commande 13b, 14b ne sont pas disposées en contact avec le matériau PCM dont elles permettent de contrôler l'état.

Dans l'un ou l'autre des exemples de commutateur RF qui viennent d'être décrit, les électrodes de commande 13a, 13b, 14a, 14b permettant de moduler la résistivité de la première région 15 de matériau PCM et les électrodes de chauffage 16a, 16b, 18a, 18b permettant de moduler la résistivité des régions 17, 19 de matériau PCM sont distinctes. Selon une autre possibilité de mise en œuvre du commutateur, on prévoit d'assurer la modulation de l'état de la région de l'interrupteur RF et d'un interrupteur de découplage DC/RF associé par le biais d'une même paire d'électrodes.

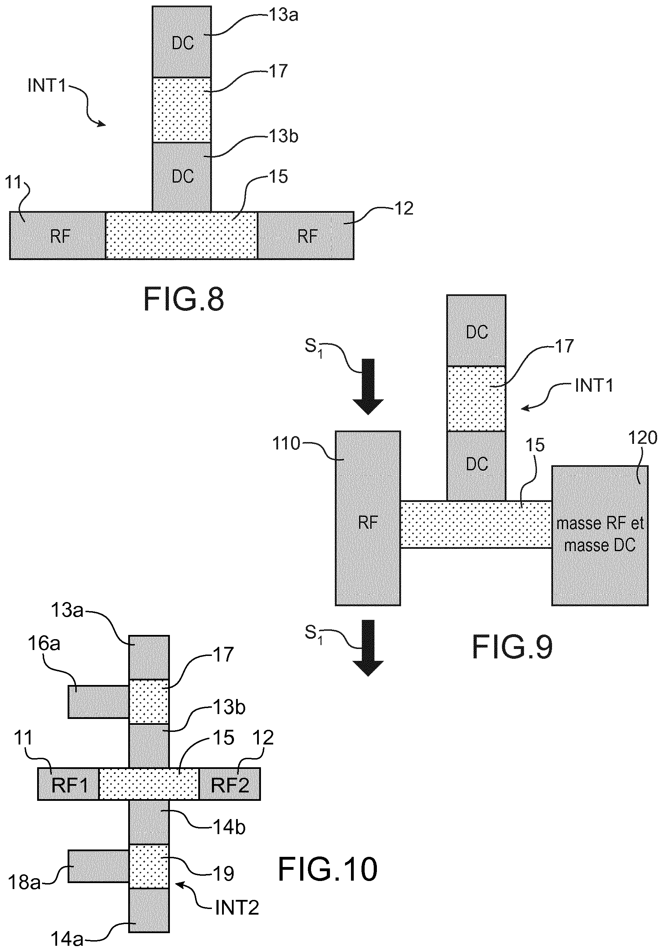

Sur la figure 8, une variante avec un seul interrupteur de découplage INT1 connecté à la région 15 de matériau PCM est prévue. Afin de réduire davantage l'encombrement du commutateur RF, il est également possible de réduire le nombre d'électrodes associées à l'interrupteur de découplage INT1. Au lieu de prévoir de se servir d'électrodes de chauffage spécifiques, on prévoit dans cet exemple d'appliquer des signaux d'activation électrique permettant de moduler l'état de la région 17 de matériau PCM de l'interrupteur de découplage, respectivement à une électrode de commande 13a et à une électrode de commande 13b

Pour modifier l'état de résistivité de la deuxième région 17 de matériau PCM, on applique un signal électrique de commande entre les électrodes de commande 13a, 13b.

Pour modifier l'état de résistivité de la première région 15 de matériau PCM on applique un signal électrique d'activation entre une électrode de commande 13a et un élément conducteur 11 ou 12.

Une telle configuration peut être utilisée pour former une dérivation commandable encore appelée « shunt » commandable telle qu'illustré sur la figure 9.

Un signal RF Si est acheminé par un premier élément conducteur sous forme d'une ligne conductrice 110 à laquelle est connectée une région 15 de matériau PCM, elle-même connectée à un interrupteur de découplage INT1.

Un signal Si circulant dans la ligne conductrice 110 lorsque la première région 15 de matériau PCM est dans son état fortement résistif. Lorsque la première région 15 est dans son état faiblement résistif, un court-circuit est créé de sorte que le signal Si est alors transmis à un deuxième élément conducteur servant de masse 120 à la fois pour la partie RF que pour la partie DC du dispositif et en particulier pour les moyens de commande d'état de la première région PCM 15.

En variante des exemples illustrés précédemment on peut prévoir au moins un interrupteur de découplage ayant une électrode remplissant à la fois la fonction d'électrode de commande et d'électrode de chauffage. L'électrode est ainsi apte à acheminer un signal de commande d'état de la première région de matériau PCM et un signal d'activation permettant de modifier l'état du matériau PCM de cet interrupteur de découplage.

Dans l'exemple de réalisation illustré sur la figure 10, pour modifier l'état d'une région 17 de matériau PCM d'un premier interrupteur de découplage INT1, on applique un signal d'activation entre une électrode 13a servant à la fois de commande et d'électrode de chauffage, et une électrode 16a servant d'électrode de chauffage. Lorsqu'on souhaite un changement de phase d'une région 19 de matériau PCM d'un deuxième interrupteur de découplage INT2, on applique un signal d'activation entre une électrode 14a de commande fonctionnant également comme électrode de chauffage, et une autre électrode 18a de chauffage. Les électrodes 13a, 13b, 14a, 14b, sont prévues pour véhiculer un signal de commande permettant de modifier l'état de la région 15 de matériau PCM de l'interrupteur RF.

On peut prévoir d'associer l'interrupteur RF à un ou plusieurs interrupteurs de découplage à base de matériau PCM 200 différent du matériau PCM 20 disposé entre les éléments conducteurs 11, 12 de l'interrupteur RF. En particulier, lorsque le matériau PCM 200 a une température de transition différente de celle du matériau PCM 20, cela favorise une commande indépendante de l'interrupteur RF et des interrupteurs de découplage.

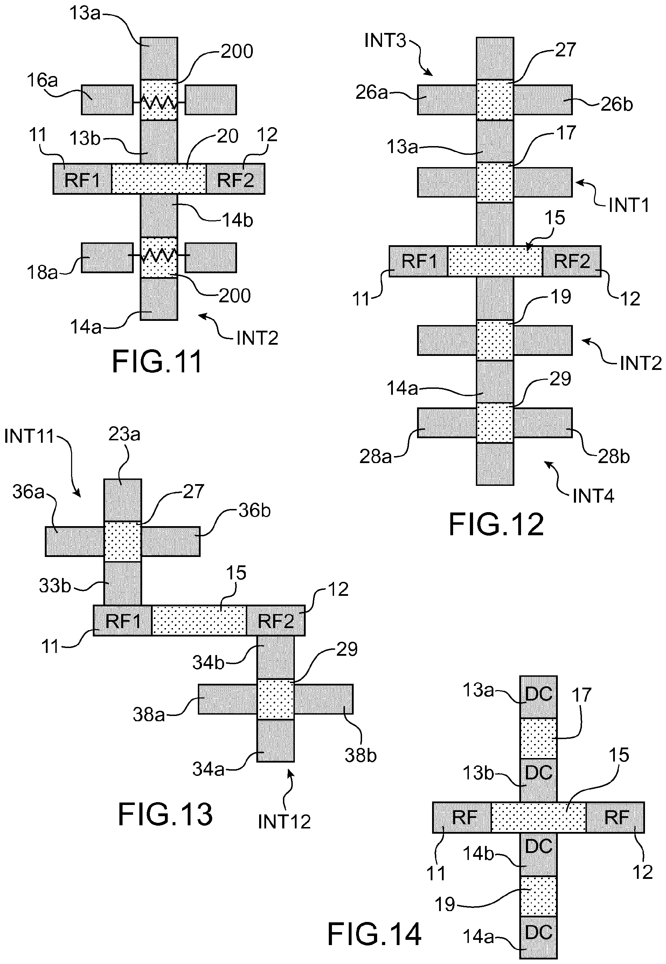

Dans un exemple de réalisation illustré sur la figure 11, l'interrupteur RF est doté d'une région 15 à base d'un premier matériau PCM 20 tel que par exemple du GeTe ou du Ge₂Sb₂Te₅. Les résistances commutées ou interrupteurs de découplage INT1, INT2 sont cette fois réalisées à l'aide d'un autre matériau à changement de phase 200, par exemple du VO₂. A température ambiante, un tel matériau est à l'état isolant, tandis qu'à une température de l'ordre de 68°C, le VO₂ subit une transformation abrupte et réversible de ses propriétés électriques et devient conducteur. Lorsque l'on souhaite commuter la première région 15 de matériau PCM, on peut faire circuler un courant entre les électrodes 16a et 16b de chauffage et entre des électrodes de chauffage 18a et 18b. Par effet joule, les résistances entre les électrodes de chauffage 16a, 16b et 18a, 18b vont chauffer. Les radiations thermiques produites permettent alors d'élever la température de leur matériau PCM 200, ici à base de VO₂, au-dessus de sa température de transition.

On peut alors faire passer un courant de commande par le biais des électrodes 13a, 14a pour modifier l'état autrement dit la phase dans laquelle se trouve le premier matériau PCM.

On peut ensuite couper le courant d'activation dans les résistances entre électrodes de chauffage 16a et 16b et entre 18a et 18b, afin de provoquer un changement d'état ou de phase du deuxième matériau PCM 200. Le deuxième matériau 200, ici du VO₂ repasse alors en-dessous de sa température de transition et assurera une isolation entre la partie interrupteur RF et la commande DC.

On peut augmenter le niveau de découplage entre la partie interrupteur RF et la partie de commande DC du commutateur RF à matériau PCM en augmentant le nombre d'interrupteurs de découplage et en plaçant un ou plusieurs interrupteurs de découplage supplémentaire(s) en série avec le ou les interrupteurs de découplage à base de matériau PCM.

Dans l'exemple de réalisation de la figure 12, des interrupteurs supplémentaires INT3 et INT4 sont disposés en série respectivement avec le premier interrupteur de découplage INT1 et le deuxième interrupteur de découplage INT2.

Les interrupteurs supplémentaires INT3 et INT4 sont dotés respectivement de régions 27, 29 de matériau à changement de phase dont l'état est commandé à l'aide d'électrodes de chauffage 26a, 26b, 28a, 28b.

Selon une variante de réalisation du commutateur RF à matériau PCM on peut prévoir d'appliquer les signaux de commande DC de l'état de la première région 15 de matériau PCM par le biais des éléments conducteurs 11, 12 par lesquels le signal RF est destiné à transiter.

La figure 13 illustre un exemple de réalisation d'une telle variante avec des interrupteurs INT11 et INT12 formés chacun d'une paire d'électrode 33a, 33b de commande (respectivement 34a, 34b) disposées de part et d'autre d'une région 27 (resp. 29) de matériau PCM dont l'état cristallin/amorphe est contrôlé au moyen d'électrodes de chauffage 36a, 36b (resp. 38a, 38b).

Les signaux DC de commande de l'état de la première région 15 de matériau PCM sont véhiculés par le biais d'électrodes 33b, 34b des interrupteurs INT11 et INT12 en contact respectivement avec le premier élément conducteur 11 et le deuxième élément conducteur 12.

La figure 14 illustre un autre exemple de réalisation, sans électrodes de chauffage de part et d'autre des régions 17, 19 de matériau à changement de phase des interrupteurs de découplage. Les électrodes de commande 13a, 13b, 14a, 14b jouent dans ce cas à la fois le rôle de commande de l'état, amorphe ou cristallin, du matériau PCM de la région 15 formant l'interrupteur RF et également d'électrodes de contrôle de l'état, amorphe ou cristallin des régions 17, 19 des interrupteurs de découplage. Un tel dispositif peut ainsi passer directement d'un état tel qu'illustré sur la figure 3A, dans lequel l'interrupteur RF et les interrupteurs de découplage sont fermés (ON) à un état tel qu'illustré sur la figure 3D où l'interrupteur RF et les interrupteurs de découplage sont ouverts (OFF), et inversement de l'état illustré sur la figure 3D à l'état illustré sur la figure 3A.

## Revendications

1. Commutateur RF apte à modifier une connexion entre au moins un premier élément conducteur (11, 110) et au moins un deuxième élément conducteur (12, 120), ledit commutateur étant adapté pour alternativement acheminer un signal RF et pour interrompre l'acheminement d'un signal RF entre le premier élément conducteur et le deuxième élément conducteur, le commutateur RF étant doté :
- d'une première région (15) à base de matériau à changement de phase (20) disposée entre le premier élément conducteur (11) et le deuxième élément conducteur (12),
- de moyens de commande d'état de ladite première région (15) de matériau à changement de phase configurés pour modifier par chauffage l'état cristallin ou amorphe dudit matériau à changement de phase de ladite première région, les moyens de commande étant dotés d'électrodes de commande (13a, 13b, 14a, 14b, 12, 120) agencées de part et d'autre de la première région (15) et prévues pour appliquer un signal électrique de commande d'état de la première région (15) de matériau à changement de phase,
le commutateur étant doté en outre d'au moins un premier interrupteur de découplage (INT1) configuré pour alternativement connecter une première électrode de commande (13a) et ladite première région (15) de matériau à changement de phase lorsque ledit premier interrupteur de découplage est passant
**caractérisé en ce que**,
le premier interrupteur de découplage (INT1) est configuré pour déconnecter la première électrode de commande (13a) et la première région (15) de matériau à changement de phase lorsque le premier interrupteur de découplage est bloqué, et **en ce que** le premier interrupteur de découplage (INT1) comprend une deuxième région (17) de matériau à changement de phase disposée entre la première électrode (13a) de commande et une deuxième électrode (13b) de commande disposée contre la première région (15) de matériau à changement de phase.

2. Commutateur RF selon la revendication 1, dans lequel le commutateur RF est doté de moyens de chauffage configurés pour placer le premier interrupteur (INT1) de découplage alternativement dans un état passant et dans un état bloqué, les moyens de chauffage étant dotés d'électrodes ( 16a, 16b, 18a, 18b) agencées de part et d'autre de ladite deuxième région (17) de matériau à changement de phase et prévues pour appliquer un signal électrique d'activation apte à modifier l'état cristallin ou amorphe dudit matériau à changement de phase de ladite deuxième région (17) de matériau à changement de phase.

3. Commutateur RF selon la revendication 2, dans lequel lesdites électrodes (16a, 16b, 18a, 18b) aptes à appliquer le signal électrique d'activation au premier interrupteur (INT1) de découplage sont des électrodes de chauffage distinctes de la première électrode de commande (13a) et de ladite deuxième électrode de commande (13b).

4. Commutateur RF selon la revendication 2, dans lequel le signal électrique d'activation est appliqué par le biais de la première électrode de commande (13a).

5. Commutateur RF selon la revendication 4, dans lequel le premier élément conducteur est une ligne conductrice (110) apte à véhiculer le signal RF d'un premier point vers un deuxième point d'un circuit RF, la première région de matériau à changement de phase (15) formant une dérivation et le deuxième élément conducteur (120) formant une masse vers laquelle le signal RF est transmis lorsque le matériau à changement de phase de ladite première région (15) est mise dans un état cristallin.

6. Commutateur RF selon la revendication 2, dans lequel le signal électrique d'activation est véhiculé par la première électrode de commande (13a) et une électrode de chauffage (16a) distincte desdites électrodes de commande.

7. Commutateur RF selon l'une des revendications précédentes, comprenant en outre un deuxième interrupteur (INT2) de découplage apte à alternativement connecter et déconnecter une autre électrode de commande (14a) et la première région (15) de matériau à changement de phase, ledit deuxième interrupteur de découplage (INT2) comprenant une autre région (19) de matériau à changement de phase disposée entre ladite autre électrode de commande (14a) et ladite première région (15) de matériau à changement de phase.

8. Commutateur RF selon la revendication 7, configuré pour alternativement passer d'un premier état à un deuxième état et inversement et pour passer du premier état du commutateur à un troisième état et inversement, et pour passer du troisième état à un quatrième état et inversement,
- le premier état du commutateur étant tel que le premier interrupteur de découplage (INT1), le deuxième interrupteur de découplage (INT2) sont passants tandis que le premier élément conducteur (11) et le deuxième élément conducteur (12) sont connectés l'un à l'autre,
- le deuxième état du commutateur étant tel que le premier interrupteur de découplage (INT1), le deuxième interrupteur de découplage (INT2) sont bloqués tandis que le premier élément conducteur (11) et le deuxième élément conducteur (12) sont connectés l'un à l'autre,
- le troisième état du commutateur étant tel que le premier interrupteur de découplage (INT1), le deuxième interrupteur de découplage (INT2) sont passants tandis que le premier élément conducteur (11) et le deuxième élément conducteur (12) sont déconnectés l'un de l'autre,
- le quatrième état du commutateur étant tel le premier interrupteur de découplage (INT1), le deuxième interrupteur de découplage (INT2) sont bloqués tandis que le premier élément conducteur et le deuxième élément conducteur sont déconnectés l'un de l'autre.

9. Commutateur RF selon la revendication 7, configuré pour alternativement passer d'un premier état à un deuxième état et inversement et pour passer du premier état du commutateur à un troisième état et inversement,
- le premier état du commutateur étant tel que le premier interrupteur de découplage (INT1), le deuxième interrupteur de découplage (INT2) sont passants tandis que le premier élément conducteur (11) et le deuxième élément conducteur (12) sont connectés l'un à l'autre,
- le deuxième état du commutateur étant tel que le premier interrupteur de découplage (INT1), le deuxième interrupteur de découplage (INT2) sont bloqués tandis que le premier élément conducteur (11) et le deuxième élément conducteur (12) sont connectés l'un à l'autre,
- le troisième état du commutateur étant tel le premier interrupteur de découplage (INT1), le deuxième interrupteur de découplage (INT2) sont bloqués tandis que le premier élément conducteur et le deuxième élément conducteur sont déconnectés l'un de l'autre.

10. Commutateur RF selon l'une des revendications 1 à 9, dans lequel la première région (15) de matériau à changement de phase est à base d'un premier matériau à changement de phase, la deuxième région (17) de matériau à changement de phase étant à base d'un deuxième matériau à changement de phase différent du premier matériau à changement de phase.

11. Commutateur selon l'une des revendications précédentes, comprenant en outre au moins un troisième interrupteur de découplage (INT3) en série avec le premier interrupteur (INT1) de découplage, le troisième interrupteur de découplage comprenant une région (27,29) de matériau à changement de phase.

12. Commutateur RF selon l'une des revendications 1 à 11, le commutateur reposant sur un substrat, la première électrode de commande (13a) comportant des connexions distinctes en plusieurs points de la première région (15) de matériau PCM, le premier élément conducteur (11) ou la première électrode (13a) étant doté(e) d'une première portion conductrice disposée dans un premier plan, d'une deuxième portion conductrice disposée dans un deuxième plan parallèle et distinct du premier plan, et d'un via conducteur reliant la première portion conductrice de la deuxième portion conductrice, la première électrode de commande (13a) s'étendant entre le premier élément conducteur (11) et le deuxième élément conducteur (12) sans être en contact avec le premier élément conducteur (11) ou le deuxième élément conducteur (12).

13. Commutateur RF selon l'une des revendications 1 à 12, dans lequel le commutateur RF est doté de moyens de chauffage configurés pour placer le premier interrupteur (INT1) de découplage alternativement dans un état passant et dans un état bloqué, les moyens de chauffage étant des moyens de chauffage indirects dotés d'électrodes de chauffage agencées de part et d'autre de ladite deuxième région de matériau à changement de phase et à distance de ladite deuxième région de matériau à changement de phase.

14. Commutateur RF selon l'une des revendications 1 à 13, dans lequel les moyens de chauffage sont dotés d'électrodes (16a, 16b) de chauffage agencées de part et d'autre de ladite deuxième région (17) de matériau à changement de phase, la deuxième région de matériau à changement de phase ayant entre ses électrodes de chauffage une dimension X2 différente d'une autre dimension Y3 correspondant à la largeur des électrodes (16a, 16b) de chauffage en contact avec la deuxième région (17) de matériau à changement de phase

15. Commutateur RF selon l'une des revendications 1 à 14, et dans lequel la deuxième région de matériau à changement de phase a entre ses électrodes de chauffage une dimension X2 différente d'une dimension X3 correspondant à la largeur de la première électrode (13a) de commande et d'une autre électrode (14b) de commande en contact de la première région de matériau à changement de phase.

## Patentansprüche

1. RF-Schalter, der dazu ausgelegt ist, eine Verbindung zwischen wenigstens einem ersten leitenden Element (11, 110) und wenigstens einem zweiten leitenden Element (12, 120) zu modifizieren, wobei der Schalter dazu ausgelegt ist, alternativ ein RF-Signal weiterzuleiten und die Weiterleitung eines RF-Signals zwischen dem ersten leitenden Element und dem zweiten leitenden Element zu unterbrechen, wobei der RF-Schalter versehen ist:
- mit einer ersten Region (15) auf Basis eines Phasenänderungsmaterials (20), die zwischen dem ersten leitenden Element (11) und dem zweiten leitenden Element (12) angeordnet ist,
- Mittel zur Steuerung des Zustands der ersten Region (15) aus Phasenänderungsmaterial, die dazu konfiguriert sind, durch Heizen den kristallinen oder amorphen Zustand des Phasenänderungsmaterials der ersten Region zu modifizieren, wobei die Steuerungsmittel mit Steuerungselektroden (13a, 13b, 14a, 14b, 12, 120) versehen sind, die auf beiden Seiten der ersten Region (15) angeordnet und dazu ausgelegt sind, ein elektrisches Signal zur Steuerung des Zustands der ersten Region (15) aus Phasenänderungsmaterial anzulegen,
wobei der Schalter ferner mit wenigstens einem Entkopplungsunterbrecher (INT1) versehen ist, der dazu konfiguriert ist, alternativ eine erste Steuerungselektrode (13a) und die erste Region (15) aus Phasenänderungsmaterial zu verbinden, wenn der erste Entkopplungsunterbrecher durchleitend ist,
**dadurch gekennzeichnet, dass** der erste Entkopplungsunterbrecher (INT1) dazu konfiguriert ist, die erste Steuerungselektrode (13a) und die erste Region (15) aus Phasenänderungsmaterial zu trennen, wenn der erste Entkopplungsunterbrecher blockiert ist, und dass der erste Entkopplungsunterbrecher (INT1) eine zweite Region (17) aus einem Phasenänderungsmaterial umfasst, die angeordnet ist zwischen der ersten Steuerungselektrode (13a) und einer zweiten Steuerungselektrode (13b), die gegen die erste Region (15) aus Phasenänderungsmaterial angeordnet ist.

2. RF-Schalter nach Anspruch 1, bei dem der RF-Schalter mit Heizmitteln versehen ist, die dazu konfiguriert sind, den ersten Entkopplungsunterbrecher (INT1) alternativ in einen durchleitenden Zustand und in einen blockierten Zustand zu versetzen, wobei die Heizmittel mit Elektroden (16a, 16b, 18a, 18b) versehen sind, die auf beiden Seiten der zweiten Region (17) aus Phasenänderungsmaterial angeordnet und dazu ausgelegt sind, ein elektrisches Aktivierungssignal anzulegen, das dazu ausgelegt ist, den kristallinen oder amorphen Zustand des Phasenänderungsmaterials der zweiten Region (17) aus Phasenänderungsmaterial zu modifizieren.

3. RF-Schalter nach Anspruch 2, bei dem die Elektroden (16a, 16b, 18a, 18b), die dazu ausgelegt sind, das elektrische Aktivierungssignal an den ersten Entkopplungsunterbrecher (INT1) anzulegen, Heizelektroden sind, die von der ersten Steuerungselektrode (13a) und von der zweiten Steuerungselektrode (13b) verschieden sind.

4. RF-Schalter nach Anspruch 2, bei dem das elektrische Aktivierungssignal mit Hilfe der ersten Steuerungselektrode (13a) angelegt wird.

5. RF-Schalter nach Anspruch 4, bei dem das erste leitende Element eine leitende Leitung (110) ist, die dazu ausgelegt ist, das RF-Signal von einem ersten Punkt in Richtung eines zweiten Punkts einer RF-Schaltung zu führen, wobei die erste Region aus Phasenänderungsmaterial (15) eine Abzweigung bildet und das zweite leitende Element (120) eine Masse bildet, in deren Richtung das RF-Signal übertragen wird, wenn das Phasenänderungsmaterial der ersten Region (15) in einen kristallinen Zustand versetzt ist.

6. RF-Schalter nach Anspruch 2, bei dem das elektrische Aktivierungssignal durch die erste Steuerungselektrode (13a) und eine Heizelektrode (16a) geführt wird, die von den Steuerungselektroden verschieden ist.

7. RF-Schalter nach einem der vorhergehenden Ansprüche, ferner umfassend einen zweiten Entkopplungsunterbrecher (INT2), der dazu ausgelegt ist, alternativ eine andere Steuerungselektrode (14a) und die erste Region (15) aus Phasenänderungsmaterial zu verbinden und zu trennen, wobei der zweite Entkopplungsunterbrecher (INT2) eine andere Region (19) aus Phasenänderungsmaterial umfasst, die angeordnet ist zwischen der anderen Steuerungselektode (14a) und der ersten Region (15) aus Phasenänderungsmaterial.

8. RF-Schalter nach Anspruch 7, der dazu konfiguriert ist, alternativ von einem ersten Zustand zu einem zweiten Zustand und umgekehrt überzugehen, und von dem ersten Zustand des Schalters zu einem dritten Zustand und umgekehrt überzugehen, und von dem dritten Zustand zu einem vierten Zustand und umgekehrt überzugehen,
- wobei der erste Zustand des Schalters derart ist, dass der erste Entkopplungsunterbrecher (INT1) und der zweite Entkopplungsunterbrecher (INT2) durchleitend sind, wohingegen das erste leitende Element (11) und das zweite leitende Element (12) miteinander verbunden sind,
- der zweite Zustand des Schalters derart ist, dass der erste Entkopplungsunterbrecher (INT1) und der zweite Entkopplungsunterbrecher (INT2) blockiert sind, wohingegen das erste leitende Element (11) und das zweite leitende Element (12) miteinander verbunden sind,
- der dritte Zustand des Schalters derart ist, dass der erste Entkopplungsunterbrecher (INT1) und der zweite Entkopplungsunterbrecher (INT2) durchleitend sind, wohingegen das erste leitende Element (11) und das zweite leitende Element (12) voneinander getrennt sind,
- der vierte Zustand des Schalters derart ist, dass der erste Entkopplungsunterbrecher (INT1) und der zweite Entkopplungsunterbrecher (INT2) blockiert sind, wohingegen das erste leitende Element und das zweite leitende Element voneinander getrennt sind.

9. RF-Schalter nach Anspruch 7, der dazu konfiguriert ist, alternativ von einem ersten Zustand zu einem zweiten Zustand und umgekehrt überzugehen, und von dem ersten Zustand des Schalters zu einem dritten Zustand und umgekehrt überzugehen,
- wobei der erste Zustand des Schalters derart ist, dass der erste Entkopplungsunterbrecher (INT1) und der zweite Entkopplungsunterbrecher (INT2) durchleitend sind, wohingegen das erste leitende Element (11) und das zweite leitende Element (12) miteinander verbunden sind,
- der zweite Zustand des Schalters derart ist, dass der erste Entkopplungsunterbrecher (INT1) und der zweite Entkopplungsunterbrecher (INT2) blockiert sind, wohingegen das erste leitende Element (11) und das zweite leitende Element (12) miteinander verbunden sind,
- der dritte Zustand des Schalters derart ist, dass der erste Entkopplungsunterbrecher (INT1) und der zweite Entkopplungsunterbrecher (INT2) blockiert sind, wohingegen das erste leitende Element und das zweite leitende Element voneinander getrennt sind.

10. RF-Schalter nach einem der Ansprüche 1 bis 9, bei dem die erste Region (15) aus Phasenänderungsmaterial auf Basis eines ersten Phasenänderungsmaterials ist, die zweite Region (17) aus Phasenänderungsmaterial auf Basis eines zweiten Phasenänderungsmaterials ist, das von dem ersten Phasenänderungsmaterial verschieden ist.

11. Schalter nach einem der vorhergehenden Ansprüche, ferner umfassend wenigstens einen dritten Entkopplungsunterbrecher (INT3) in Reihe mit dem ersten Entkopplungsunterbrecher (INT1), wobei der dritte Entkopplungsunterbrecher eine Region (27, 29) aus einem Phasenänderungsmaterial umfasst.

12. RF-Schalter nach einem der Ansprüche 1 bis 11, wobei der Schalter auf einem Substrat ruht, wobei die erste Steuerungselektrode (13a) verschiedene Anschlüsse an mehreren Punkten der ersten Region (15) aus PCM-Material umfasst, wobei das erste leitende Element (11) oder die erste Elektrode (13a) mit einem ersten leitenden Bereich versehen ist, der in einer ersten Ebene angeordnet ist, mit einem zweiten leitenden Bereich, der in einer zweiten Ebene parallel und von der ersten Ebene getrennt angeordnet ist, und mit einem Leitungsdurchgang, der den ersten leitenden Bereich und den zweiten leitenden Bereich verbindet, wobei die erste Steuerungselektrode (13a) sich zwischen dem ersten leitenden Element (11) und dem zweiten leitenden Element (12) erstreckt, ohne in Kontakt mit dem ersten leitenden Element (11) oder dem zweiten leitenden Element (12) zu sein.

13. RF-Schalter nach einem der Ansprüche 1 bis 12, bei dem der RF-Schalter mit Heizmitteln versehen ist, die dazu konfiguriert sind, den ersten Entkopplungsunterbrecher (INT1) alternativ in einen durchleitenden Zustand und in einen blockierten Zustand zu versetzen, wobei die Heizmittel indirekte Heizmittel sind, die mit Heizelektroden versehen sind, die auf beiden Seiten der zweiten Region aus Phasenänderungsmaterial und in einem Abstand von der zweiten Region aus Phasenänderungsmaterial angeordnet sind.

14. RF-Schalter nach einem der Ansprüche 1 bis 13, bei dem die Heizmittel mit Heizelektroden (16a, 16b) versehen sind, die auf beiden Seiten der zweiten Region (17) aus Phasenänderungsmaterial angeordnet sind, wobei die zweite Region aus Phasenänderungsmaterial zwischen ihren Heizelektroden eine Abmessung X2 hat, die verschieden ist von einer anderen Abmessung Y3 entsprechend der Breite der Heizelektroden (16a, 16b) in Kontakt mit der zweiten Region (17) aus Phasenänderungsmaterial.

15. RF-Schalter nach einem der Ansprüche 1 bis 14, bei dem die zweite Region aus Phasenänderungsmaterial zwischen ihren Heizelektroden eine Abmessung X2 hat, die verschieden ist von einer Abmessung X3 entsprechend der Breite der ersten Steuerungselektrode (13a) und einer anderen Steuerungselektrode (14b) in Kontakt mit der ersten Region aus Phasenänderungsmaterial.

## Claims

1. An RF switch adapted to modify a connection between at least one first conductive element (11, 110) and at least one second conductive element (12, 120), said switch being adapted to alternately route an RF signal and stop routing an RF signal between the first conductive element and the second conductive element, the RF switch being provided with:
- a first region (15) based on a phase change material (20) disposed between the first conductive element (11) and the second conductive element (12),
- state control means for said first region (15) of phase change material which are configured to modify by heating the crystal or amorphous state of said phase change material of said first region, the control means being provided with control electrodes (13a, 13b, 14a, 14b, 12, 120) arranged on either side of the first region (15) and provided to apply a state control electrical signal for the first region (15) of phase change material,
the switch being further provided with at least one first decoupling switch (INT1) configured to alternately connect a first control electrode (13a) and said first region (15) of phase change material when said first decoupling switch is ON and to disconnect the first control electrode (13a) and the first region (15) of phase change material when the decoupling switch is OFF, the first decoupling switch (INT1) comprising a second region (17) of phase change material disposed between the first control electrode (13a) and a second control electrode (13b, the second control electrode being disposed against the first region (15) of phase change material.

2. The RF switch according to claim 1, wherein the RF switch is provided with heating means configured to place the first decoupling switch (INT1) alternately to an ON state and to an OFF state, the heating means being provided with electrodes (13a, 13b 16a, 16b, 18a, 18b) arranged on either side of said second region (17) of phase change material and provided to apply an activating electrical signal able to modify the crystal or amorphous state of said phase change material of said second region (17) of phase change material.

3. The RF switch according to claim 2, wherein said electrodes (16a, 16b, 18a, 18b) able to apply the activating electrical signal to the first decoupling switch (INT1) are heating electrodes distinct from the first control electrode (13a) and from said second control electrode (13b).

4. The RF switch according to claim 2, wherein the activating electrical signal is applied through the first control electrode (13a).

5. The RF switch according to claim 4, wherein the first conductive element is a conductive line (110) able to convey the RF signal from a first point to a second point of an RF circuit, the first region of phase change material (15) forming a shunt and the second conductive element (120) forming a ground to which the RF signal is transmitted when the phase change material of said first region (15) is brought to a crystal state.

6. The RF switch according to claim 2, wherein the activating electrical signal is conveyed by the first control electrode (13a) and a heating electrode (16a) distinct from said control electrodes.

7. The RF switch according to any of the preceding claims, further comprising a second decoupling switch (INT2) able to alternately connect and disconnect another control electrode (14a) and the first region (15) of phase change material, said second decoupling switch (INT2) comprising another region (19) of phase change material disposed between said other control electrode (14a) and said first region (15) of phase change material.

8. The RF switch according to claim 7, configured to alternately switch from a first state to a second state and reversely and to switch from the first state of the switch to a third state and reversely, and to switch from the third state to a fourth state and reversely,
- the first state of the switch being such that the first decoupling switch (INT1), the second decoupling switch (INT2) are ON whereas the first conductive element (11) and the second conductive element (12) are connected to each other,
- the second state of the switch being such that the first decoupling switch (INT1), the second decoupling switch (INT2) are OFF whereas the first conductive element (11) and the second conductive element (12) are connected to each other,
- the third state of the switch being such that the first decoupling switch (INT1), the second decoupling switch (INT2) are ON whereas the first conductive element (11) and the second conductive element (12) are disconnected from each other,
- the fourth state of the switch being such that the first decoupling switch (INT1), the second decoupling switch (INT2) are OFF whereas the first conductive element and the second conductive element are disconnected from each other.

9. The RF switch according to claim 7, configured to alternately switch from a first state to a second state and reversely and to switch from the first state of the switch to a third state and reversely,
- the first state of the switch being such that the first decoupling switch (INT1), the second decoupling switch (INT2) are ON whereas the first conductive element (11) and the second conductive element (12) are connected to each other,
- the second state of the switch being such that the first decoupling switch (INT1), the second decoupling switch (INT2) are OFF whereas the first conductive element (11) and the second conductive element (12) are connected to each other,
- the third state of the switch being such that the first decoupling switch (INT1), the second decoupling switch (INT2) are OFF whereas the first conductive element and the second conductive element are disconnected from each other.

10. The RF switch according to any of the claims 1 to 9, wherein the first region (15) of phase change material is based on a first phase change material, the second region (17) of phase change material being based on a second phase change material different from the first phase change material.

11. The switch according to any of the preceding claims, further comprising at least one third decoupling switch (INT3) in series with the first decoupling switch (INT1), the third decoupling switch comprising a region (27, 29) of phase change material.

12. The RF switch according to any of the claims 1 to 11, the switch lying on a substrate, the first control electrode (13a) including distinct connections at several points of the first region (15) of PCM material, the first conductive element (11) or the first electrode (13a) being provided with a first conductive portion disposed in a first plane, a second conductive portion disposed between a second plane parallel and distinct from the first plane, and a conductive via connecting the first conductive portion of the second conductive portion, the first control electrode (13a) extending between the first conductive element (11) and the second conductive element (12) without contacting the first conductive element (11) or the second conductive element (12).

13. The RF switch according to any of the claims 1 to 12, wherein the RF switch is provided with heating means configured to place the first decoupling switch (INT1) alternately to an ON state and to an OFF state, the heating means being indirect heating means provided with heating electrodes arranged on either side of said second region of phase change material and remote from said second region of phase change material.

14. The RF switch according to any of the claims 1 to 13, wherein the heating means are provided with heating electrodes (16a, 16b) arranged on either side of said second region (17) of phase change material, the second region of phase change material having between its heating electrodes a dimension X2 different from another dimension Y3 corresponding to the width of the heating electrodes (16a, 16b) in contact with the second region (17) of phase change material.

15. The RF switch according to any of the claims 1 to 14, and wherein the second region of phase change material has between its heating electrodes a dimension X2 different from a dimension X3 corresponding to the width of the first control electrode (13a) and of another control electrode (14b) in contact with the first region of phase change material.
